# EUROPEAN PATENT APPLICATION

(11) **EP 2 747 512 A1**
(43) Date of publication of application: **25.06.2014**
(21) Application number: 12845060.8
(22) Date of filing: 06.03.2012
(51) Int. Cl.: H05B 3/00, B23K 1/008, B23K 3/04, F27D 19/00, H05K 3/34

(54) **FURNACE, CONTROL DEVICE THEREFOR, CONTROL METHOD THEREFOR, AND STORAGE MEDIUM**

(30) Priority: 02.11.2011 JP 2011241259
(71) Applicant: Omron Corporation, Kyoto-shi, Kyoto 600-8530 (JP)
(72) Inventor: TAKAICHI, Ryuichiro, Kyoto-shi Kyoto 600-8530 (JP); ENDO, Maki, Kyoto-shi Kyoto 600-8530 (JP); KAWARATANI, Seiichiro, Kyoto-shi Kyoto 600-8530 (JP)
(74) Representative: Kilian Kilian & Partner
(86) International application number: PCT/JP2012/055690
(87) International publication number: WO 2013/065333

(57) **Abstract**

In a control device (100) for a furnace, a control unit (101) operates a supply unit according to a first condition and a second condition. In the first condition, the furnace is maintained in a first state, in which an object to be heated is subjected to heat treatment. In the second condition, the supply unit is controlled such that the furnace is controller in a state in which less energy is consumed compared with the maintenance of the furnace in the first state. The control unit (101) operates the supply unit such that the furnace is maintained in the first state, when remaining time to time the furnace should be returned to the first state is less than or equal to reference return time while the supply unit is operated according to the second condition.

## Description

### TECHNICAL FIELD

The present invention relates to control of a furnace, particularly to reduction of energy consumption in the furnace in a suitable mode.

### BACKGROUND ART

Conventionally, reduction of energy consumption has been studied in diverse ways, and various technologies have been proposed for the reduction of energy consumption in the industrial field.

For example, Non-Patent Document 1 (Sadayoshi Ito, Tomoyasu Murakami, Naoya Ryoki, Daisuke Tabata, Naoko Matsuda, Hiroyuki Naka, "Energy-saving top runner factory implemented by energy-saving solution technology", Panasonic Technical Journal Vol. 57 No. 1 Apr. 2011, [online], search date (Sept. 20, 2011), the Internet <UPL: http://panasonic.co.jp/ptj/v5701/pdf/p0106.pdf>) discloses a technology for reducing energy used in a factory. In the technology, an energy-saving waiting mode in which supply and exhaust air volume is decreased in a production waiting state of a reflow furnace, a drying furnace, and a baking furnace.

### PRIOR ART DOCUMENT

### NON-PATENT DOCUMENT

Non-Patent Document 1: Sadayoshi Ito, Tomoyasu Murakami, Naoya Ryoki, Daisuke Tabata, Naoko Matsuda, Hiroyuki Naka, "Energy-saving top runner factory implemented by energy-saving solution technology", Panasonic Technical Journal Vol. 57 No. 1 Apr. 2011, [online], search date (Sept. 20, 2011), the Internet <UPL: http://panasonic.co.jp/ptj/v5701/pdf/p0106.pdf>

### SUMMARY OF THE INVENTION

### PROBLEMS TO BE SOLVED BY THE INVENTION

An energy problem is one that is always needed to be studied. However, in the case that the reduction of the energy consumption is achieved in the factory, it is necessary to establish a balance between the reduction of the energy consumption and maintenance of production efficiency of a product.

The present invention has been devised to solve the above problem, and an object thereof is to establish the balance between the reduction of the energy consumption and the maintenance of the production efficiency in a factory.

### MEANS FOR SOLVING THE PROBLEM

In accordance with one aspect of the present invention, a control device for a furnace includes a control unit configured to control an operation of a supply unit that supplies energy into the furnace. The control unit operates the supply unit according to a first condition that the furnace is maintained in a first state, in which an object to be heated is subjected to heat treatment, and the control unit operates the supply unit according to a second condition that the furnace is controlled in a state in which less energy is consumed compared with the maintenance of the state in the furnace in the first state, when a predetermined condition is satisfied. The control unit further includes a storage unit in which reference return time is stored, and the reference return time is time necessary to return the furnace to the first state from the state in which the supply unit is operated according to the second condition. The control unit operates the supply unit such that the furnace is maintained in the first state, when remaining time to time the furnace should be returned to the first state is less than or equal to the reference return time while the supply unit is operated according to the second condition.

Preferably a plurality of contents are stored in the storage unit as a content of the second condition, and the control unit measures and presents reserve return time and a consumption energy amount with respect to each of the plurality of contents of the second condition, the reserve return time being time necessary to return the furnace to the first state from control under the second condition, the consumption energy amount being an energy amount consumed by the supply unit.

Preferably the control device further includes an input unit configured to input the reference return time, and the control unit presents the consumption energy amount corresponding to the reserve return time when time input to the input unit as the reference return time is the reserve return time in measurement results of the reserve return time and the consumption energy amount.

Preferably the control unit interrupts the supply of energy to the furnace by the supply unit in the control under the second condition.

Preferably the first state is a state in which a temperature in the furnace is greater than or equal to a specific temperature, and the control unit maintains the furnace at a temperature lower than the specific temperature in the control under the second condition.

Preferably the first state is a state in which an oxygen concentration in the furnace is less than or equal to a specific concentration, and the control unit maintains the furnace at an oxygen concentration higher than the specific concentration in the control under the second condition.

Preferably the predetermined condition is a condition that the object to be heated does not exist in the furnace. Preferably time when the control should be performed under the second condition is greater than or equal to the reference return time in the predetermined condition.

Preferably the time when the control should be performed under the second condition is decided based on whether the object to be heated exists in a preceding process of the furnace.

In accordance with another aspect of the present invention, a storage medium is a computer-readable storage medium in which a program is non-transiently recorded, and the program is executable by a computer configured to control an operation of a supply unit, the supply unit being configured to supply energy into a furnace. The program causes the computer to perform the steps of: operating the supply unit according to a first condition that the furnace is maintained in a first state, in which an object to be heated is subjected to heat treatment; operating the supply unit according to a second condition that the furnace is controlled in a state in which less energy is consumed compared with the maintenance of the furnace in the first state, when a predetermined condition is satisfied; and operating the supply unit such that the furnace is maintained in the first state, when remaining time to time the furnace should be returned to the first state is less than or equal to a reference return time while the supply unit is operated according to the second condition, the reference return time being time necessary to return the furnace to the first state from the state in which the supply unit is operated according to the second condition.

In accordance with still another aspect of the present invention, a furnace control method is a control method in which a furnace control device controls an operation of a supply unit configured to supply energy into the furnace. The furnace control method includes the steps of: operating the supply unit according to a first condition that the furnace is maintained in a first state, in which an object to be heated is subjected to heat treatment; operating the supply unit according to a second condition that the furnace is controlled in a state in which less energy is consumed compared with the maintenance of the furnace in the first state, when a predetermined condition is satisfied; and operating the supply unit such that the furnace is maintained in the first state, when remaining time to time the furnace should be returned to the first state is less than or equal to reference return time while the supply unit is operated according to the second condition, the reference return time being time necessary to return the furnace to the first state from the state in which the supply unit is operated according to the second condition.

In accordance with yet another aspect of the present invention, a furnace includes: the control device; and a supply unit configured to supply energy into the furnace.

### EFFECT OF THE INVENTION

According to the present invention, the control device controls the supply unit that supplies the energy into the furnace in a mode in which an environment in the furnace is permitted to become a low-energy-consumption state such as a lower temperature and a high oxygen concentration compared with the case that the object to be heated is subjected to the heat treatment. Additionally, when the remaining time until the heat treatment of the object to be heated is resumed is less than or equal to the reference return time, the control device ends the control of the supply unit in the mode, and controls the supply unit in a mode in which the object to be heated is subjected to the heat treatment.

Therefore, the balance between the reduction of the energy consumption and the maintenance of the production efficiency in the factory can be established.

### BRIEF DESCRIPTION OF THE DRAWINGS

Fig. 1 is a view illustrating an entire configuration of a board processing system including a reflow furnace according to a first embodiment.
Fig. 2 is a view schematically illustrating a configuration of the reflow furnace.
Fig. 3 is a control block diagram of the reflow furnace in Fig. 2.
Fig. 4 is a diagram illustrating an example of switching of an operating mode in the reflow furnace.
Figs. 5(A) and 5(B) schematically illustrate an example of a temperature change pattern of a furnace of the first embodiment of the present invention.
Fig. 6 is a graph schematically illustrating a time change of the number of boards introduced to an inert atmosphere chamber.
Fig. 7 is a graph schematically illustrating the time change (solid line) of a power consumed by a heater and an integrated value (alternate long and short dash line) from the beginning of an operation of the heater.
Fig. 8 is a graph schematically illustrating the time change of an atmospheric temperature in a seventh heating process in the inert atmosphere chamber.
Fig. 9 is a graph schematically illustrating the time change (solid line) of a nitrogen flow rate detected by a flowmeter and the integrated value (alternate long and short dash line) of the nitrogen flow rate.
Fig. 10 is a graph schematically illustrating the time change of an oxygen concentration detected by an oxygen concentration sensor.
Fig. 11 is a flowchart of processing (teaching processing) that is performed by a controller in order to set reference return time.
Fig. 12 is illustrates an example of data used in the teaching processing.
Fig. 13 schematically illustrates an example of a graph displayed through processing in Step SA90.
Fig. 14 is a view illustrating an example of a screen that presents an electric energy consumption estimated to be suppressed.
Fig. 15 is a flowchart of operating control processing.
Fig. 16 illustrates an example of a flowchart of remaining waiting time calculation processing.
Fig. 17 is a flowchart of the teaching processing performed in a second embodiment of the present invention.
Fig. 18 is illustrates an example of the data used in the teaching processing.
Fig. 19 schematically illustrates an example of the graph displayed through processing in Step SD90.
Fig. 20 is a flowchart of the teaching processing performed in a third embodiment of the present invention.
Fig. 21 illustrates an example of the data used in the teaching processing.
Fig. 22 schematically illustrates an example of the graph displayed through processing in Step SE90.

### MODE FOR CARRYING OUT THE INVENTION

Hereinafter, embodiments of a furnace of the present invention will be described with reference to the drawings. In the drawings, the identical component is designated by the identical symbol, and the overlapping description is neglected.

In the following embodiments, a reflow furnace is cited as an example of the furnace. However, the furnace of the present invention is not limited to the reflow furnace, but the furnace may be a drying furnace or a baking furnace as long as a processing target object is heated in the furnace.

### [First embodiment]

### <Schematic configuration>

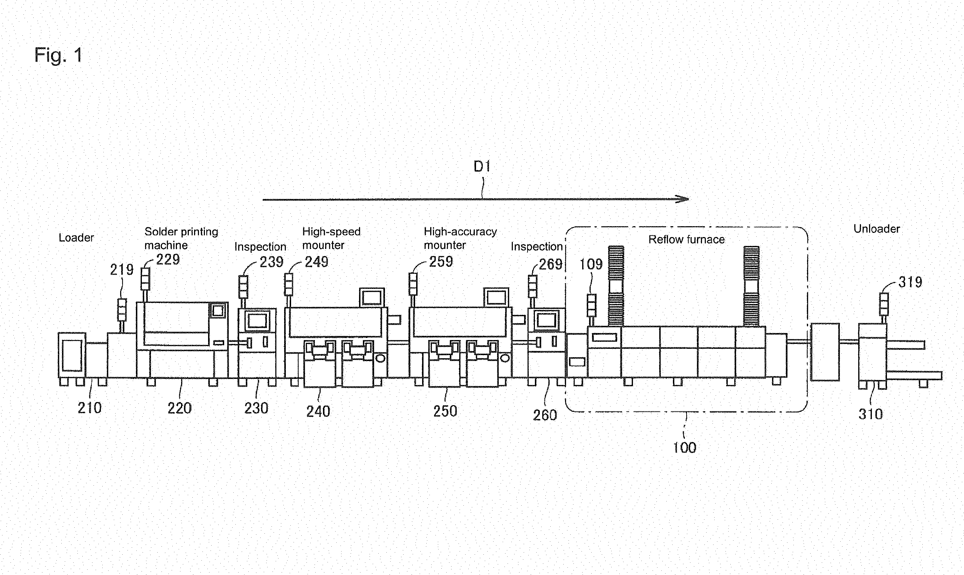

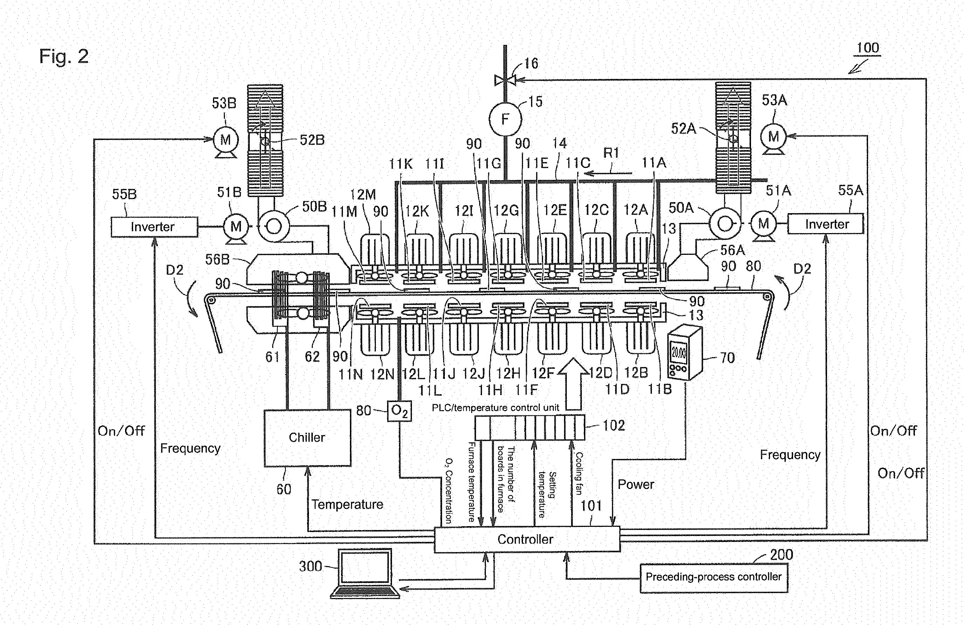

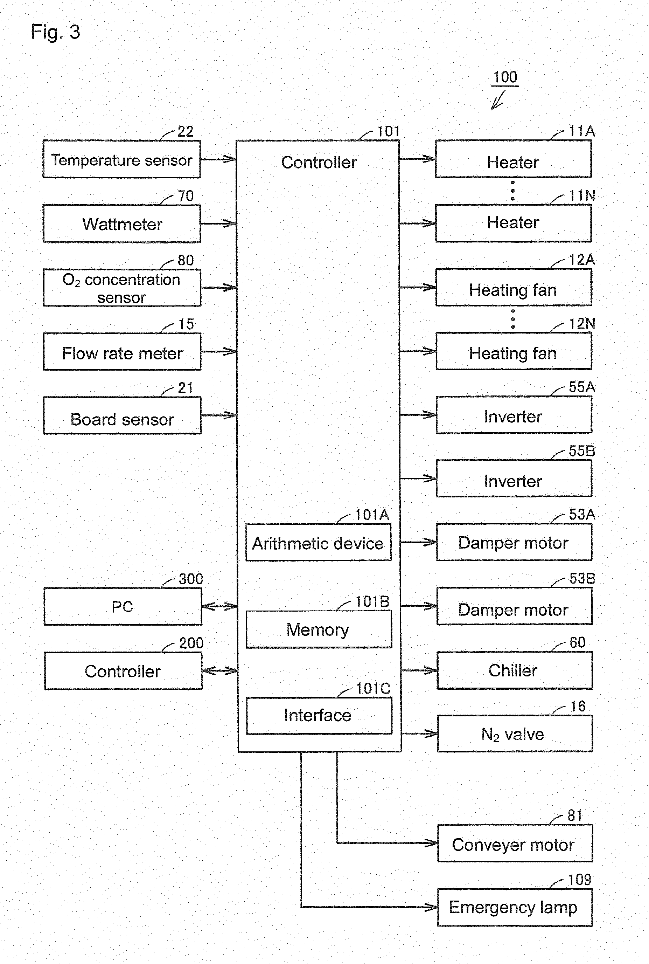

Fig. 1 is a view illustrating an entire configuration of a board processing system including a reflow furnace according to a first embodiment. Fig. 2 is a view schematically illustrating a configuration of the reflow furnace. Fig. 3 is a control block diagram of the reflow furnace in Fig. 2.

### (1) Schematic configuration of board processing system

The board processing system in Fig. 1 is a system that mounts an electronic component on a printed board.

Referring to Fig. 1, in the board processing system, the printed board to be processed is sequentially sent to a loader 210, a solder printing machine 220, an inspection device 230, a high-speed mounter 240, a high-accuracy mounter 250, an inspection device 260, a reflow furnace 100, and an unloader 310. In Fig. 1, an arrow D1 indicates a conveying direction of the printed board.

The solder printing machine 220 prints solder on the printed board sent from the loader 210, the inspection device 230 inspects a print aspect, the high-speed mounter 240 and the high-accuracy mounter 250 mount the electronic components on the printed board, the inspection device 260 inspects a mounting aspect, and the printed board on which the electronic components are mounted is sent to the reflow furnace 100. Hereinafter, the printed board sent to the reflow furnace 100 while the electronic components are mounted thereon is referred to as a "workpiece".

After the solder is melted to fix the electronic components in the reflow furnace 100, the workpiece is sent to various processes through the unloader 310.

The loader 210, the solder printing machine 220, the inspection device 230, the high-speed mounter 240, the high-accuracy mounter 250, the inspection device 260, the reflow furnace 100, and the unloader 310 include emergency lamps 219, 229, 239, 249, 259, 269, 109, and 319, respectively. Each operation of the emergency lamps 219, 229, 239, 249, 259, 269, 109, and 319 is controlled by each control device. The control device lights on the emergency lamp corresponding to each device when an emergency situation is generated.

### (2) Schematic configuration of reflow furnace

Referring to Fig. 2, a workpiece 90 sent from the inspection device 260 is transported in the reflow furnace 100, while placed on a conveyer 80. In Fig. 2, arrow D2 indicates a rotating direction of the conveyer 80.

An inert atmosphere chamber 13 is provided in the reflow furnace 100. A duct 56A is provided on an upstream side of the inert atmosphere chamber 13, and a duct 56B is provided on a downstream side.

Fans 50A and 50B and opening and closing plates 52A and 52B are provided in the ducts 56A and 56B, respectively. The fans 50A and 50B are driven by motors 51A and 51 B, and inverters 55A and 55B supply powers to the motors 51A and 51B.

The opening and closing plates 52A and 52B are provided in order to adjust degrees of air flows in the ducts 56A and 56B. Damper motors 53A and 53B control opening degrees of the opening and closing plates 52A and 52B in blast passages of the ducts 56A and 56B.

In the case that the solder used in the workpiece 90 is what is called lead-free solder, namely, in the case that an oxygen concentration is desirably decreased, a nitrogen gas is delivered in the inert atmosphere chamber 13 through a nitrogen line 14 in order to decrease the oxygen concentration. The amount of the nitrogen gas introduced to the inert atmosphere chamber 13 is controlled by controlling the opening degree of a nitrogen valve (hereinafter also referred to as an "N₂ valve") 16. A flowmeter 15 detects the flow rate of the nitrogen gas in the nitrogen line 14. An oxygen concentration sensor (hereinafter also referred to as an "O₂ concentration sensor") 80 is provided in the reflow furnace in order to detect the oxygen concentration in the inert atmosphere chamber 13.

Seven sets of heating devices including heaters 11 A and 11B, heaters 11C and 11D, heaters 11E and 11 F, heaters 11G and 11H, heaters 11I and 11 J, heaters 11 K and 11L, and heaters 11M and 11N are provided in the inert atmosphere chamber 13 in order to heat the workpiece at seven stages. Each set of heating devices includes the heater disposed above the conveyer 80 and the heater disposed below the conveyer 80. In the reflow furnace, a wattmeter 70 measures the powers consumed by the heaters 11 A to 11N.

Fans 12A and 12B, fans 12C and 12D, fans 12E and 12F, fans 12G and 12H, fans 12I and 12J, fans 12K and 12L, and fans 12M and 12N are provided near the heaters in order to stir air in the inert atmosphere chamber 13.

The workpiece 90 heated by the heaters 11A and 11B, the heaters 11C and 1D, the heaters 11E and 11 F, the heaters 11G and 11H, the heaters 11I and 11J, the heaters 11K and 11 L, the heaters 11M and 11N in the inert atmosphere chamber 13 is sent to the duct 56B, and cooled by the chiller 60. The chiller 60 includes cooling pipes 61 and 62. Then the workpiece 90 is sent to a next process (for example, the unloader 310 in Fig. 1).

Temperature sensors (not illustrated) are provided in the inert atmosphere chamber 13 and the duct 56B. A temperature control unit 102 performs feedback control to the operations of the heaters 11 A to 11N based on the temperatures detected by the temperature sensors. A controller 101 is also provided in the reflow furnace in order to totally control the operations of elements such as the heaters 11A to 11N based on a detection output of the wattmeter 70 or the oxygen concentration sensor 80.

A personal computer (hereinafter also referred to as a "PC") 300 that acts as a monitor and a device (controller 200) that controls the device, such as the inspection devices 230 and 260, which is provided in a preceding process of the reflow furnace 100 in the board processing system (see Fig. 1), are connected to the controller 101. As described later, the controller 101 may control the operations of the elements such as the heaters 11 A to 11N based on information acquired from the PC 300 or the controller 200.

### (3) Control block of reflow furnace

Referring to Fig. 3, in the reflow furnace 100, the controller 101 is connected to a temperature sensor 22, a board sensor 21, a conveyer motor 81, and the emergency lamp 109 in Fig. 1 in addition to the devices such as the heaters 11A to 11N in Fig. 2. The temperature sensor 22 detects an atmospheric temperature at each of the seven stages of the heating process (each set of heaters) in the inert atmosphere chamber 13 and an atmospheric temperature near the duct 56B by which the workpiece 90 passes. The board sensor 21 detects the number of boards introduced to the inert atmosphere chamber 13. The conveyer motor 81 rotates the conveyer 80. In Fig. 3, it is assumed that the temperature control unit 102 in Fig. 2 is included in the controller 101.

Based on the detection output of the temperature sensor 22, the controller 101 performs the feedback control, such as PID (Proportional Integral Differential) control, to the heating operations of the heaters 11A to 11N so as to maintain the heaters 11A to 11N at temperatures decided in the heating processes. The controller 101 also performs the feedback control to the opening degree of the nitrogen valve 16 based on the detection output of the oxygen concentration sensor 80. The controller 101 controls an atmosphere cooling aspect, such as circulating amounts of coolants in the cooling pipe 61 and 62 of the chiller 60, in the duct 56B based on the detection output of the atmospheric temperature in the duct 56B from the temperature sensor 22.

The controller 101 lights on the emergency lamp 109 after taking such a well-known measure that the heating with the heaters 11 A to 11 N is stopped, and that the conveyance of the workpiece 90 with the conveyer 80 is stopped, in the case that the situation in which a predetermined operation cannot normally be performed is generated in the board processing system, for example, in the case that the temperature in the inert atmosphere chamber 13 is abnormally increased, or in the case that a trouble with the conveyer 80 is generated in the conveyance of the workpiece 90. After fixing the trouble with the reflow furnace, an operator resets the controller 101, and resumes the operation of the reflow furnace.

The controller 101 includes an arithmetic device 101 A such as a CPU (Central Processing Unit), a memory 101B in which various pieces of data such as a program are stored, and an interface 101C that is used during communication between the controller 101 and the PC 300 or the controller 200. The interface 101C is constructed by a communication device such as a network card. The arithmetic device 101A executes the program stored in the memory 101B, thereby performing a control operation of the controller 101. Alternatively, the controller 101 may be constructed by at least one hardware device (such as an LSI (Large Scale Integration)) that implements each function of the controller 101.

The memory 101B may be constructed by a storage medium that is detachably attached to a main body of the controller 101. A medium in which the program is stored in a nonvolatile manner can be cited as an example of the storage medium. That is, examples of the storage medium include a CD-ROM (Compact Disk-Read Only Memory), a DVD-ROM (Digital Versatile Disk-Read Only Memory), a USB (Universal Serial Bus) memory, a memory card, an FD (Flexible Disk), a hard disk, a magnetic tape, a cassette tape, an MO (Magnetic Optical) disk, an MD (Mini Disk), an IC (Integrated Circuit) card (excluding the memory card), an optical card, a mask ROM, an EPROM, and an EEPROM (Electronically Erasable Programmable Read Only Memory).

### <Outline of energy-saving control in reflow furnace>

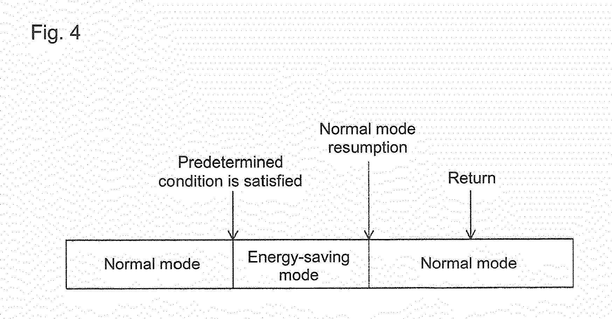

Fig. 4 is a diagram illustrating an example of switching of an operating mode in the reflow furnace. In Fig. 4, a horizontal axis indicates time.

Referring to Fig. 4, when the operation of the reflow furnace is started, the controller 101 controls each element of the reflow furnace in a normal mode in which the state (such as the temperature and the oxygen concentration) of the inert atmosphere chamber 13 is maintained so as to be suitable for heat treatment of the workpiece 90.

When such a predetermined condition that the workpiece 90 is not conveyed to the inert atmosphere chamber 13 for given time is satisfied during the control in the normal mode, the controller 101 controls each element of the reflow furnace in a mode (hereinafter also referred to as an "energy-saving mode") in which consumed electric energy per unit time of the reflow furnace is lower than that of the normal mode. The predetermined condition is decided by the inputs to the controller 101 from the preceding-process controller 200, the PC 300, and other input devices.

During the control in the energy-saving mode, the controller 101 returns the control mode of each element of the reflow furnace to the normal mode on condition that remaining time (hereinafter also referred to as "remaining waiting time") to a clock time necessary to return the state of the inert atmosphere chamber 13 to the state suitable for the heat treatment of the workpiece 90 is less than or equal to time (hereinafter also referred to as "reference return time") necessary to return the state of the inert atmosphere chamber 13 from the state under the control in the energy-saving mode to the state suitable for the heat treatment.

The workpiece 90 is conveyed to the inert atmosphere chamber 13 again on condition that the state of the inert atmosphere chamber 13 returns to the state suitable for the heat treatment after the normal mode is resumed.

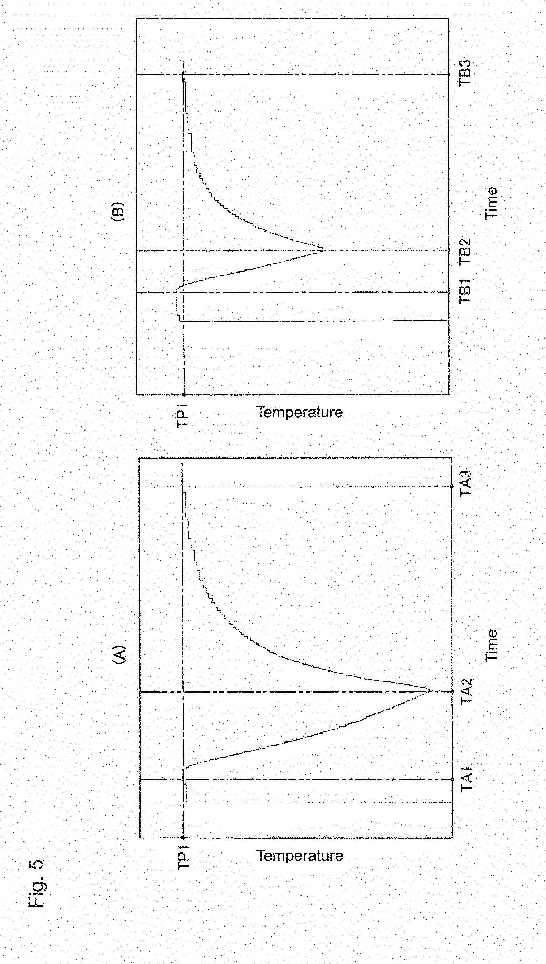

Figs. 5(A) and 5(B) schematically illustrate an example of a change pattern of a change in atmospheric temperature in a seventh heating process in the inert atmosphere chamber 13 when the operating mode is switched as described with reference to Fig. 4. Figs. 5(A) and 5(B) illustrate two temperature change patterns. In Figs. 5(A) and 5(B), a vertical axis indicates the atmospheric temperature and the horizontal axis indicates time. Figs. 5(A) and 5(B) are equal to each other in scales of the vertical axis and the horizontal axis.

In the example of Fig. 5(A), supplies of the powers to the heaters 11A to 11N are interrupted at clock time TA1 after the atmospheric temperature reaches a first temperature ("TP1" in Fig. 5(A)). Therefore, the atmospheric temperature decreases. Then the supplies of the powers to the heaters 11A to 11 N are resumed at clock time TA2. Therefore, the atmospheric temperature increases, and the atmospheric temperature returns to TP1 at clock time TA3.

In the example of Fig. 5(B), the supplies of the powers to the heaters 11A to 11N are interrupted at clock time TB1 after the atmospheric temperature reaches TP1. Therefore, the atmospheric temperature decreases. Then the supplies of the powers to the heaters 11 A to 11N are resumed at clock time TB2. Therefore, the atmospheric temperature increases, and the atmospheric temperature returns to TP1 at clock time TB3.

The example of Fig. 5(A) is longer than the example of Fig. 5(B) in the time for which the supplies of the powers to the heaters 11 A to 11N are interrupted. That is, the time from clock time TA1 to clock time TA2 is longer than the time from the clock time TB1 to clock time TB2.

Therefore, in the example of Fig. 5(A), the atmospheric temperature decreases to a lower temperature compared with the example of Fig. 5(B).

The example of Fig. 5(A) is longer than the example of Fig. 5(B) in the time for which the atmospheric temperature returns to TP1 after the supplies of the powers to the heaters 11A to 11N are resumed. That is, the time from clock time TA2 to clock time TA3 is longer than the time from the clock time TB2 to the clock time TB3.

As to the temperature control in the normal mode, based on the detection output of the temperature sensor 22, turn-on and -off of each of the heaters 11A to 11N (or the powers supplied to the heathers 11A to 11N) are controlled such that the inert atmosphere chamber 13 is maintained at the temperature (hereinafter also referred to as a "first temperature") suitable for the heat treatment of the workpiece 90. In the first embodiment, the atmospheric temperatures of the heating processes at the seven stages are measured, and the operations of the heaters 11A to 11N are controlled such that the atmospheric temperatures in the heating processes at the seven stages are suitable for the heat treatment of the workpiece 90. As used herein, the "first temperature" means the atmospheric temperatures in the heating process at the seventh stage.

Examples of the control in the energy-saving mode include control in which the supplies of the powers to the heaters 11A to 11N are interrupted for given time (the heaters 11 A to 11N are continuously turned off for the given time) and control of the operations of the heaters 11 A to 11N for the purpose of maintaining the inert atmosphere chamber 13 at the temperature lower than the first temperature. Even in the control of the latter, the heaters 11A to 11N may temporarily be turned off in the case that the temperature at the inert atmosphere chamber 13 is higher than or equal to the first temperature while the operations of the heaters 11A to 11N are continuously controlled. On the other hand, in the control of the former, namely, the "control in which the supplies of the powers to the heaters 11A to 11N are interrupted" means that the supplies of the powers to the heaters 11A to 11N are interrupted for the given time while the operations of the heaters 11A to 11N are not controlled. In the first embodiment, the control of the former is described as the control in the energy-saving mode. The control of the latter is described in a second embodiment.

A specific control content in the energy-saving mode is described later.

### <Behavior in reflow furnace>

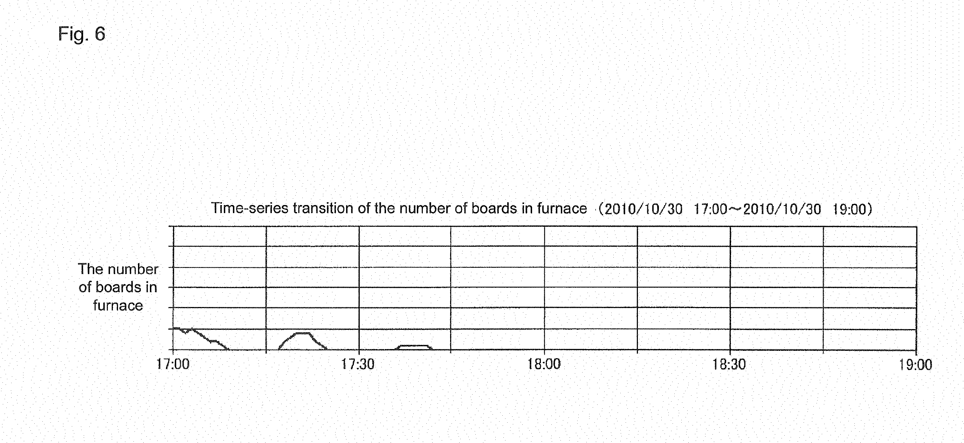

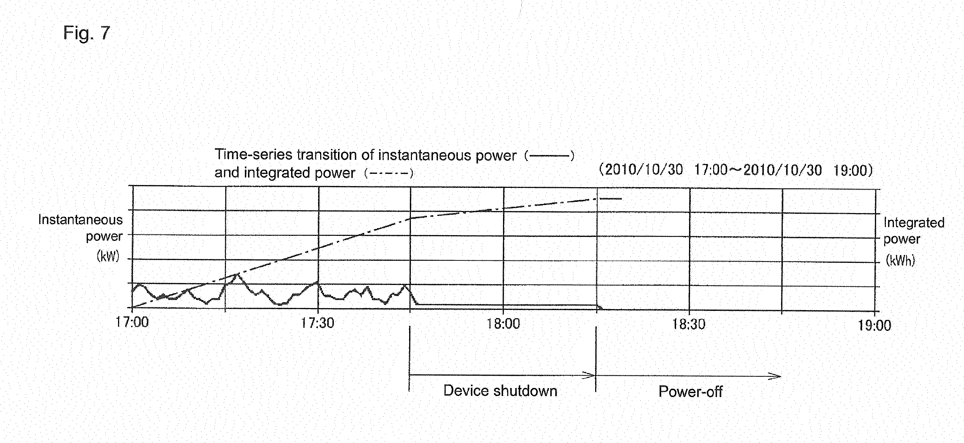

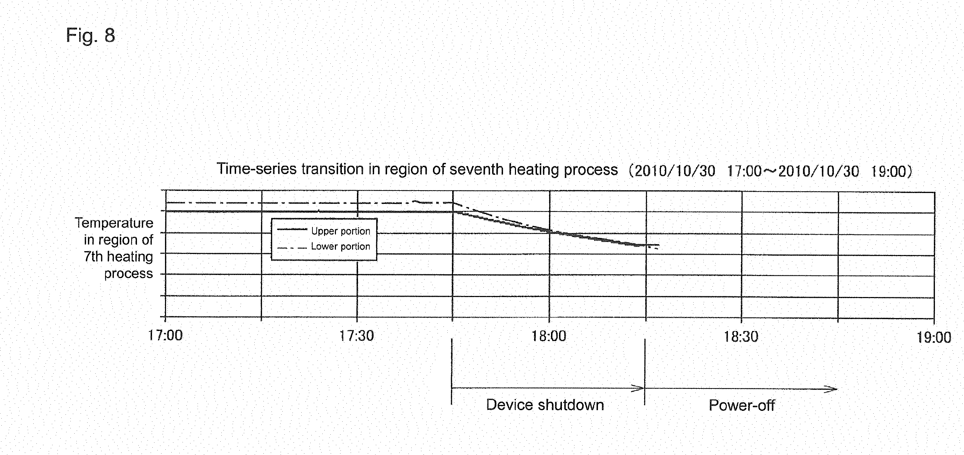

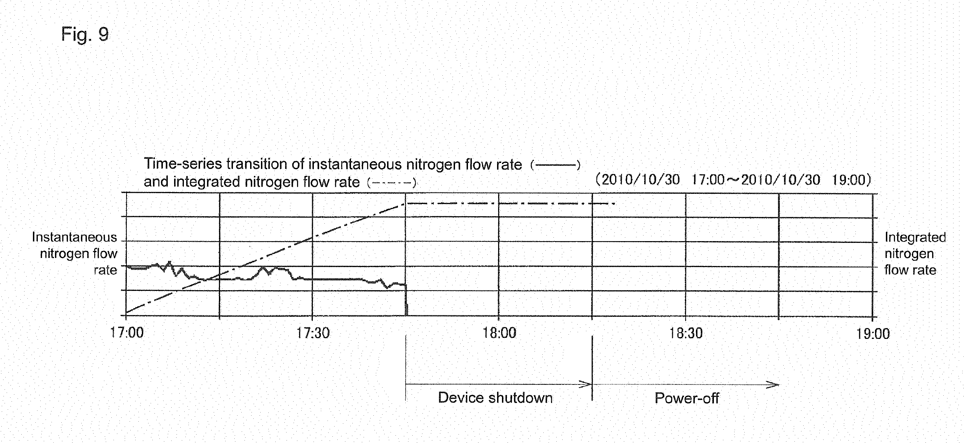

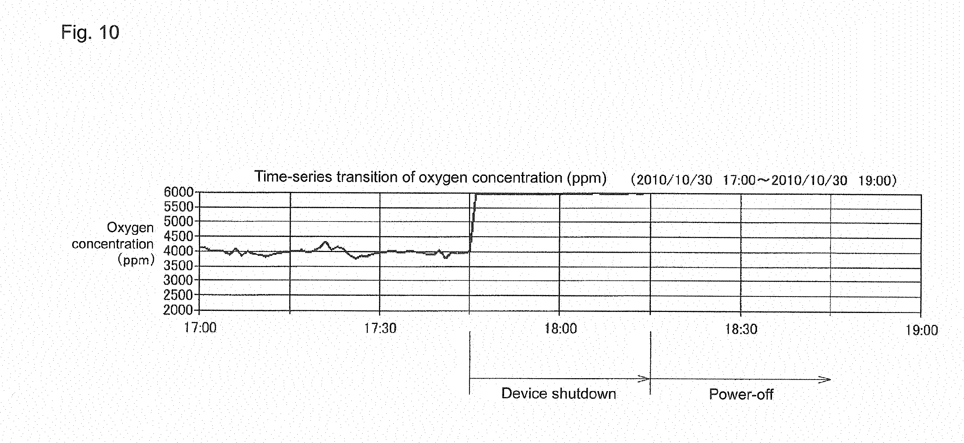

Fig. 6 is a graph schematically illustrating a time change of the number of boards introduced to the inert atmosphere chamber 13. Fig. 7 is a graph schematically illustrating the time change (solid line) of a power consumed in the reflow furnace and an integrated value (alternate long and short dash line) from the beginning of an operation of the reflow furnace. Fig. 8 is a graph schematically illustrating the time change of the atmospheric temperature in a seventh heating process (the heating process at the position where the heaters 11M and 11N are disposed) in the inert atmosphere chamber 13. In Fig. 8, a solid line (indicated as an "upper portion") indicates a detection temperature in a portion above the conveyer 80 in the region where the 7th heating process is performed, and a solid line (indicated as a "lower portion") indicates a detection temperature in a portion below the conveyer 80 in the region where the seventh heating process is performed. Fig. 9 is a graph schematically illustrating the time change (solid line) of the nitrogen flow rate detected by the flowmeter 15 and the integrated value (alternate long and short dash line) of the nitrogen flow rate. Fig. 10 is a graph schematically illustrating the time change of the oxygen concentration detected by the oxygen concentration sensor 80.

In Figs. 6 to 10, the horizontal axis indicates a clock time when the measurement is performed. The measurement clock time is common in Figs. 6 to 10. In Figs. 6 to 10, for example, "17:30" expresses 17:30 on the same day.

Fig. 6 illustrates the state in which the introduction of the board to the inert atmosphere chamber 13 is interrupted for a predetermined time frame after17:20.

It is assumed that, while the introduction of the board to the inert atmosphere chamber 13 is interrupted for the predetermined time frame, the supplies of the powers to the heaters 11A to 11N are interrupted in order to suppress power consumption in the reflow furnace, and nitrogen valve 16 is closed in order to suppress consumption of pressure energy in the reflow furnace.

In this case, the supplies of the powers to the heaters 11 A to 11N are interrupted after17:45. As used herein, the "17:45" means the clock time when the "final" workpiece 90 of which the introduction to the inert atmosphere chamber 13 is detected at 17:20 is sent to the next process of the reflow furnace through the inert atmosphere chamber 13 and the duct 56B. As indicated by "device shutdown" in Fig. 7, the power consumption (solid line) decreases in the heaters 11A to 11N by interrupting the supplies of the powers to the heaters 11A to 11N.

Specifically, in Fig. 7, the power consumption decreases rapidly in the reflow furnace from around 17:45 to around 18:15, because only the heating fans 12A to 12N consume the power while the heaters 11A to 11N are interrupted. The supply of the power to the reflow furnace is stopped (power-off) at18:15.

After 17:45, the nitrogen valve 16 is closed to stop the supply of the nitrogen gas to the inert atmosphere chamber 13. Therefore, as illustrated in Fig. 9, nitrogen supply amount (the flow rate indicated by the solid line in Fig. 9) decreases.

That is, according to the stopping (or the decrease) of the supplies of the powers to the heaters 11 to 11N as described with reference to Fig. 7, the atmospheric temperature in the inert atmosphere chamber 13 decreases in the reflow furnace of the first embodiment as illustrated in Fig. 8. According to the closing of the nitrogen valve 16 as described with reference to Fig. 9, the oxygen concentration increases in the inert atmosphere chamber 13 as illustrated in Fig. 10.

In the case that the atmospheric temperature decreases in the inert atmosphere chamber 13 as described above, a certain amount of time is required until the temperature in the inert atmosphere chamber 13 is increased to the temperature suitable for the heat treatment of the workpiece 90 by resuming the supplies of the powers to the heaters 11 A to 11N.

In the case that the oxygen concentration increases in the inert atmosphere chamber 13 as described above, a certain amount of time is required until the oxygen concentration in the inert atmosphere chamber 13 is decreased to the concentration suitable for the heat treatment of the workpiece 90 by opening the nitrogen valve 16 to increase the supply of the nitrogen gas into the inert atmosphere chamber 13.

The description, that the temperature in the inert atmosphere chamber 13 is increased so as to be suitable for the heat treatment of the workpiece 90 after the temperature is once decreased is referred to as "resumption". That the temperature in the inert atmosphere chamber 13 is decreased so as to be suitable for the heat treatment of the workpiece 90 after the temperature is once increased is also referred to as "resumption".

### <Setting of reference return time>

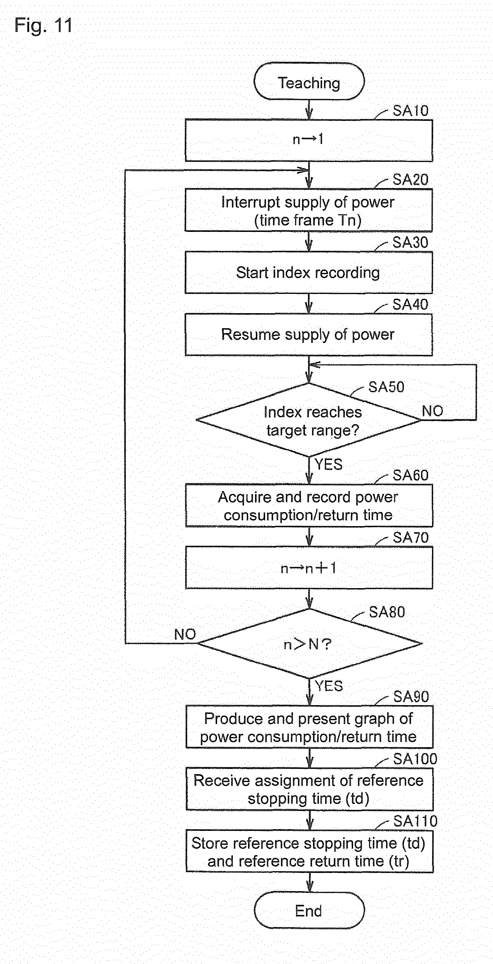

Fig. 11 is a flowchart of reference return time setting processing (teaching processing) performed by the controller 101. For example, the teaching processing is started in the reflow furnace, when an instruction to perform the teaching processing is issued while the temperature in the inert atmosphere chamber 13 is adjusted so as to be suitable for the heat treatment of the workpiece 90, or when the reflow furnace is started up. For example, the instruction to perform the teaching processing is input from the PC 300 through the interface 101C. The controller 101 may include an input device such as a mouse, a keyboard, and a touch panel, and the instruction to perform the teaching processing may be issued by the operation of the input device.

Referring to Fig. 11, the controller 101 initializes a variable n used in the teaching processing to 1 in Step SA10, and goes to processing in Step SA20.

The controller 101 interrupts the supplies of the powers to the heaters 11 A to 11N for a time frame Tn in Step SA20, and goes to processing in Step SA30. As used therein, the time frame Tn is a predetermined value correlated with a value of the variable n. Pieces of information identifying N time frames (T1 to TN), each of which is previously defined as a length of time necessary to interrupt the supply of the power in the teaching processing, are stored in the memory 101B. In Step SA20, the controller 101 acquires the information identifying an nth time frame in the N time frames from the memory 101 B, and interrupts the supplies of the powers to the heaters 11A to 11N for the time frame concerned.

The controller 101 starts to detect an index (in the first embodiment, the atmospheric temperature of the seventh heating process) in the inert atmosphere chamber 13 in Step SA30, and goes to the processing in Step SA40.

The controller 101 resumes the supplies of the powers to the heaters 11A to 11N in Step SA40, and goes to processing in Step SA50. Therefore, the supplies of the powers to the heaters 11 A to 11 N are resumed at a time point when the time frame Tn has elapsed since the supplies of the powers to the heaters 11A to 11N are interrupted in Step SA20.

In Step SA50, the controller 101 determines whether the index has reached a control target range. When determined that the index has reached a control target range, the controller 101 goes to the processing in Step SA60. That is, the controller 101 goes to the processing in Step SA60 when the atmospheric temperature has reached the first temperature.

The controller 101 acquires power consumption and return time and records the power consumption and the return time in the memory 101B in Step SA60, and the controller 101 goes to the processing in Step SA70. As used herein, the power consumption means power consumption in the heaters 11A to 11N until the atmospheric temperature reaches the first temperature in Step SA50 since the supply of the power is resumed after the supplies of the powers to the heaters 11A to 11N are interrupted in Step SA20. The return time is time until the atmospheric temperature reaches the first temperature in Step SA50 since the supply of the power is resumed in Step SA40. The term of "reach" may be substituted for a condition that is generally used to identify the return of the temperature such that "the first temperature is continuously retained for predetermined time since the atmospheric temperature reaches the first temperature".

The controller 101 updates the variable n by adding 1 to the variable n in Step SA70, and goes to processing in Step SA80.

In Step SA80, the controller 101 determines whether the value of the variable n exceeds "N" that is the number of time frames. The controller 101 returns to the processing in Step SA20 when the value of the variable n does not exceed "N" yet, and the controller 101 goes to the processing in Step SA90 when the value of the variable n exceeds "N".

That is, the controller 101 acquires the "power consumption" and the "return time" for each of the N time frames through the pieces of processing in Steps SA20 to SA80.

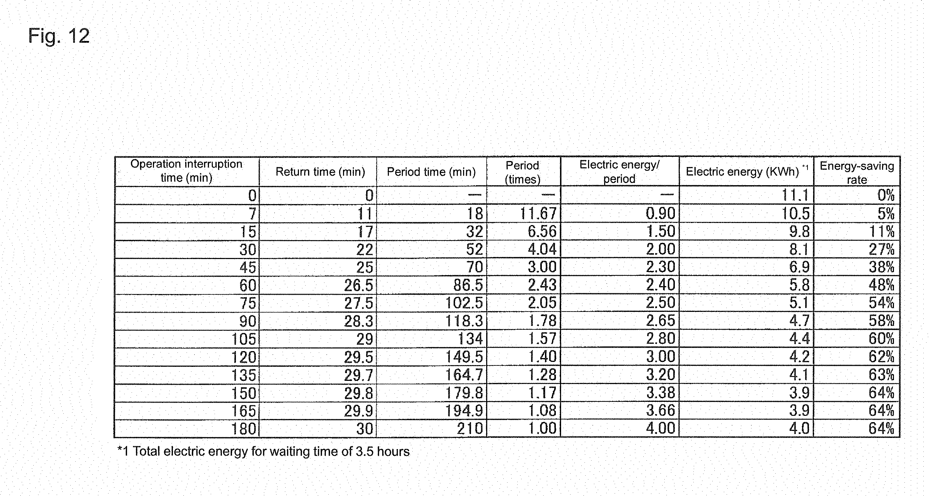

Fig. 12 illustrates an example of the data used in the teaching processing, and the data includes the data acquired through the pieces of processing in Steps SA20 to SA80.

Fig. 12 illustrates pieces of data of items of an operation interruption time and the return time, period time, a period, electric energy/period, the electric energy, and an energy-saving rate for each pieces of operation interruption time.

The "operation interruption time" means the time frame Tn. The "return time" means the return time acquired in Step SA60 with respect to each operation interruption time.

The "period time" means a sum of the operation interruption time and the return time. The "period" means the number of times the period time can be repeated for a specific time (in this example, 3.5 hours (210 minutes)), and means a value that is obtained by dividing the "specific time" by the "period time".

The "electric energy/period" means electric energy that is consumed in the period time, and means the power consumption acquired in Step SA60.

The "electric energy" means a product of the "electric energy/period" and the "period", specifically means the power consumption that is estimated to be consumed for the specific time when the interruption of the supply of the power in the operation interruption time and the supply of the power in the return time are repeated.

Fig. 12 also illustrates the data in the case that, assuming that the "operation interruption time" is set to "0 minutes", the powers are continuously supplied to the heaters 11A to 11N for the specific time.

The "energy-saving rate" means a difference between the "electric energy" and the "electric energy" in the case that the "operation interruption time" is set to "0 minutes", and the "energy-saving rate" corresponds to the electric energy of which the consumption can be suppressed compared with the case that the continuous operation is performed for the specific time.

In Fig. 12, the pieces of data are indicated for the operation interruption times of 0 minutes (the continuous supply of the power), 7 minutes, 15 minutes, 30 minutes, 45 minutes, 60 minutes, 75 minutes, 90 minutes, 105 minutes, 120 minutes, 135 minutes, 150 minutes, 165 minutes, and 180 minutes.

Referring to Fig. 12, the "electric energy" is "10.5 KWh" and "3.5 KWh" for the operation interruption times of 7 minutes and 150 minutes. In these time frames, the "electric energy" decreases with increasing operation interruption time. The "electric energy" for the operation interruption time of 165 minutes does not change from the "electric energy" for the operation interruption time of 150 minutes. The "electric energy" is "4.0 KWh" for the operation interruption time of 180 minutes, and increases slightly compared with the operation interruption times of 150 minutes and 165 minutes.

The "energy-saving rate" is "5%" and "64%" for the operation interruption times of 7 minutes and 150 minutes. The "energy-saving rate" exerts a tendency similar to the "electric energy" with respect to the operation interruption time.

Referring to Fig. 11, in Step SA90, the controller 101 produces screen data used to display graphs indicating the changes in "power consumption" (the "electric energy" in Fig. 12) and "return time" (the "return time" in Fig. 12) with the change in operation interruption time, and transmits the screen data to the PC 300. The graphs are displayed on the monitor of the PC 300 through the processing in Step SA90. Alternatively, the controller 101 may include the monitor, and the graphs may be displayed on the monitor of the controller 101.

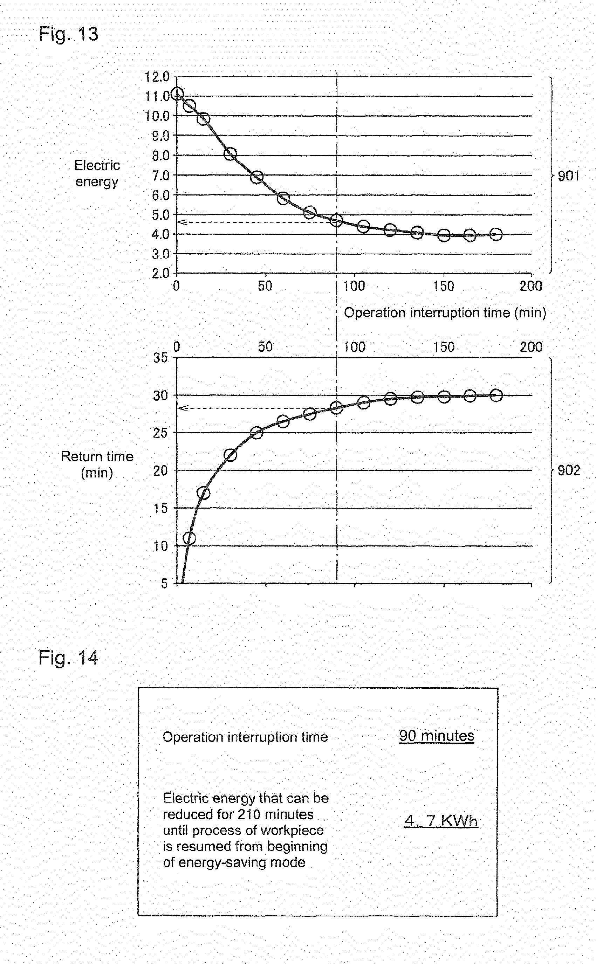

Fig. 13 schematically illustrates examples of the graphs displayed through the processing in Step SA90.

Fig. 13 illustrates a graph 901 and a graph 902. The graph 901 indicates the change in "power consumption" (the "electric energy" in Fig. 12) with the change in operation interruption time. The graph 902 indicates the change in "return time" (the "return time" in Fig. 12) with the change in operation interruption time.

A horizontal position of the horizontal axis indicating the operation interruption time is common to the graph 901 and the graph 902. Accordingly, when setting the operation interruption time, a user can recognize the electric energy estimated to be consumed for the specific time and the time necessary to return the environment (temperature) in the inert atmosphere chamber 13 by seeing the graphs in Fig. 13.

An approximate function produced based on each piece of data is indicated by a thick line in each of the graph 901 and the graph 902. The controller 101 may generate the approximate function based on the measured value of the electric energy or return time, which is associated with the change in operation interruption time as illustrated in Fig. 12, and may display the approximate function together with the measured value as indicated by the graph 901 and the graph 902.

Referring to Fig. 11, in Step SA100, the controller 101 receives assignment of time (hereinafter also referred to as "reference stopping time (td)") when the supplies of the powers to the heaters 11A to 11N are interrupted during the actual operation. Then the controller 101 goes to the processing in Step SA110.

For example, the user can assign the reference stopping time (td) while referring to the graphs illustrated in Fig. 13. Specifically, for example, the user performs an operation to specify the operation interruption time by moving in a right or left direction the position of the alternate long and short dash line in Fig. 13 and an operation to assign the specified operation interruption time as the reference stopping time (td) on the PC 300, whereby information assigning the reference stopping time (td) is input to the controller 101 from the PC 300 through the interface 101C.

Note that the time assigned as the reference stopping time (td) is not limited to the time, which is indicated as the "operation interruption time" in Fig. 12 while having the measured value of the electric energy or the like.

In specifying the operation interruption time on the PC 300, information indicating the electric energy and return time corresponding to the operation interruption time may be displayed on the PC 300 as illustrated by a broken-line arrow in Fig. 13. For example, the display of the corresponding electric energy and return time is implemented as a CGI (Common Gateway Interface) on the controller 101. That is, for example, the arithmetic device 101A executes a CGI program stored in the memory 101B in response to a request from the PC 300, whereby the data used to display the electric energy and return time corresponding to the operation interruption time specified on the PC 300 is transmitted to the PC 300 from the controller 101. In the case that the data in Fig. 12 is stored in the memory 101B, the arithmetic device 101A executes the CGI program using the data.

Referring to Fig. 11, in Step SA110, the controller 101 stores the reference stopping time (td), the assignment of which is received in Step SA100, in the memory 101B, and stores the return time corresponding to the operation interruption time having the length equal to the reference stopping time (td) in the approximate function or the measured value in Fig. 12 in the memory 101B as a "reference return time (tr)". Then the controller 101 ends the processing.

In the teaching processing, the electric energy consumption estimated to be suppressed for the specific time may be presented according to the set reference stopping time (td).

Fig. 14 is a view illustrating an example of a screen that presents the electric energy consumption estimated to be suppressed.

In Fig. 14, the time assigned as the reference stopping time (td) is displayed as the "operation interruption time". In Fig. 14, the electric energy corresponding to the operation interruption time equal to the reference stopping time (td) in the graph 901 in Fig. 13 is displayed as the "electric energy that can be reduced". For example, the controller 101 executes the CGI program to acquire the electric energy corresponding to the assigned reference stopping time (td) based on Fig. 12 or on the approximate function, which is produced based on the mode of the change in operation interruption time of the electric energy in Fig. 12, and transmits the information used to display the electric energy to the PC 300.

### <Normal operating control>

Processing (operating control processing), which is performed by the controller 101 when the workpiece 90 is introduced to the inert atmosphere chamber 13 to perform the heat treatment of the workpiece 90 in the reflow furnace, will be described below. For example, the processing is performed in starting up the reflow furnace.

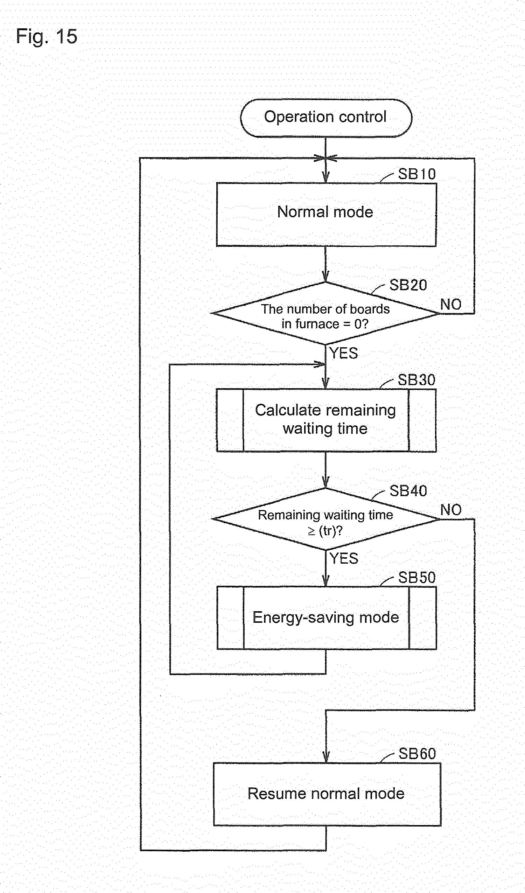

Fig. 15 is a flowchart of the operating control processing. Referring to Fig. 15, the controller 101 controls the operation of each element of the reflow furnace including the heaters 11A to 11N in the normal mode in Step SB10, and goes to the processing in Step SB20.

In Step SB20, the controller 101 determines whether the number of boards (workpieces 90) introduced to the inert atmosphere chamber 13 is 0 by referring to the detection output of the board sensor 21. When the number of boards is 0, the controller 101 goes to the processing in Step SB30.

The controller 101 calculates the remaining waiting time in Step SB30, and goes to the processing in Step SB40. The remaining waiting time means processing of calculating the remaining time to the clock time when the board (workpiece 90) is input to the inert atmosphere chamber 13 the next time (or the clock time when the board is scheduled to be input). For example, next input-scheduled clock time is previously stored in the memory 101B, and the controller 101 calculates a difference between present clock time and the next input-scheduled clock time to perform the processing in Step SB30.

In Step SB40, the controller 101 determines whether the remaining waiting time is greater than or equal to the reference return time (tr). The controller 101 goes to processing in Step SB50 when the remaining waiting time is greater than or equal to the reference return time (tr), and the controller 101 goes to processing in Step SB60 when the remaining waiting time is less than the reference return time (tr).

The controller 101 performs the control in the energy-saving mode in Step SB50, and returns to the processing in Step SB30.

As to the specific control content in the energy-saving mode, for example, the interruption of the supplies of the powers to the heaters 11A to 11N during the reference stopping time (td) and the supplies of the powers to the heaters 11A to 11N during the reference return time (tr) under the feedback control in which the inert atmosphere chamber 13 is put into the state suitable for the heat treatment of the workpiece 90 are repeatedly continued.

On the other hand, the controller 101 performs the control in the normal mode in Step SB60, and returns to the processing in Step SB10.

According to the operating control processing, unless the workpiece 90 is introduced to the inert atmosphere chamber 13, each element of the reflow furnace is controlled in the energy-saving mode until the remaining time (remaining waiting time) to the time when the workpiece 90 is input the next time becomes equal to the reference return time (tr) stored in the memory 101B. When the remaining waiting time becomes less than or equal to the reference return time (tr), the control of each element of the reflow furnace is returned to the normal mode.

The energy-saving mode is a mode in which an energy consumption amount in a member (such as the heaters 11A to 11 N) that supplies the energy to the inert atmosphere chamber 13 is lower than that in the normal mode.

The energy consumption amount in the member that supplies the energy can be suppressed through the operating control processing in Fig. 15 while the environment (such as the temperature) in the inert atmosphere chamber 13 is surely returned to the state suitable for the heat treatment of the workpiece 90 at the next input-scheduled clock time.

### <Remaining waiting time calculation processing>

In the remaining waiting time calculation processing in Step SB30 of the operating control processing in Fig. 15, the remaining waiting time is calculated based on the next input-scheduled clock time and the present clock time.

Alternatively, the remaining waiting time may be calculated based on the state of the device (such as the inspection device 230) different from the reflow furnace in the board processing system.

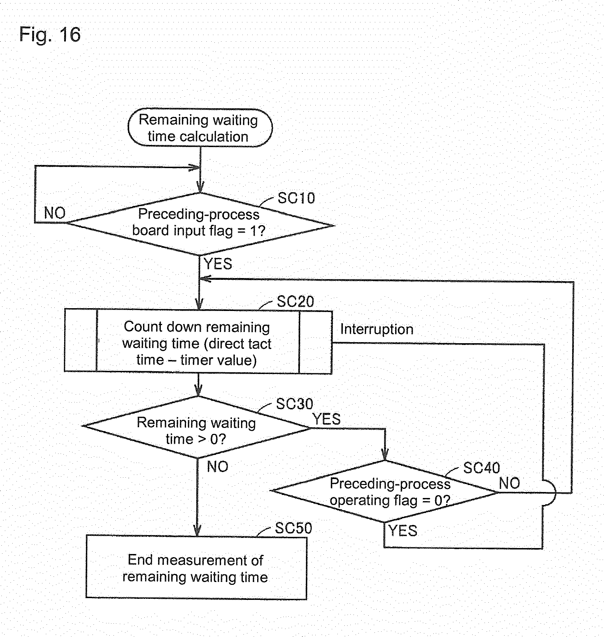

Fig. 16 illustrates an example of a flowchart of the remaining waiting time calculation processing. For example, the processing in Fig. 16 is performed in a background of the processing in Fig. 15. Preferably the processing in Step SB30 of Fig. 15 is eliminated when the processing in Fig. 16 is performed.

Referring to Fig. 16, in Step SC10, the controller 101 determines whether a value of a preceding-process board input flag is 1. The preceding-process board input flag is a flag that is set to "1" when the board is input to a specific device (such as the inspection device 230) that performs processing on the board before the reflow furnace 100 in the board processing system, and is set to "0" when the board is not input to the specific device. For example, the controller 101 updates the value of the preceding-process board input flag by receiving the signal indicating whether the board is input from the controller (the "controller 200" in Fig. 3) of the specific device, and the controller 101 uses the value of the preceding-process board input flag in the remaining waiting time calculation processing.

When the value of a preceding-process board input flag is 1 in Step SC10, the controller 101 goes to the processing in Step SC20.

The controller 101 counts down the remaining waiting time in Step SC20, and goes to the processing in Step SC30. The initial value of the remaining waiting time is a tact time in the case that the board is directly sent from the specific device to the reflow furnace. The initial value is the sum of the tact times of the devices in the case that the board (workpiece 90) passes through a plurality of devices between the specific device and the reflow furnace. In Step SC20, the remaining waiting time is updated by performing the countdown from the initial value. In Step SC20 from the second time, the countdown is performed from the post-update remaining waiting time.

In Step SC30, the controller 101 determines whether the remaining waiting time exceeds 0. The controller 101 goes to the processing in Step SC40 when the remaining waiting time exceeds 0, and the controller 101 goes to the processing in Step SC50 when the remaining waiting time is less than or equal to 0.

In Step SC40, the controller 101 determines whether a preceding-process operating flag is 0. The preceding-process operating flag is a flag indicating whether the specific device runs normally. The preceding-process operating flag has the value of "1" when the specific device runs normally, and has the value of "0" when the specific device does not run normally (generation of abnormality). The controller 101 properly updates the value of the preceding-process operating flag by conducting communication with the specific device. For example, the controller 101 may receive a lighting/turn-out signal transmitted to the emergency lamp (such as the emergency lamp 239) in the specific device, and update the value of the preceding-process operating flag based on the content of the signal. That is, the preceding-process operating flag is updated to "0" when the signal lighting the emergency lamp is transmitted to the emergency lamp, and the preceding-process operating flag is updated to "1" when the signal turning off the emergency lamp is transmitted to the emergency lamp. When the preceding-process operating flag has the value of "1", the controller 101 returns to the processing in Step SC20. On the other hand, when the preceding-process operating flag has the value of "0", the controller 101 interrupts the countdown of the remaining waiting time in Step SC20 until the value of the preceding-process operating flag is returns to "1". When the value of the preceding-process operating flag is returns to "1", the countdown in Step SC20 is resumed.

As described above, in the remaining waiting time calculation processing, the remaining waiting time is updated according to the running state of the device in the preceding process of the reflow furnace in the board processing system in which the reflow furnace is included. Therefore, in the operating control processing in Fig. 15, the timing for returning the environment in the inert atmosphere chamber 13 can be selected according to the present situation. When the timing for introducing the board to the reflow furnace is delayed due to a trouble with the device of the preceding process, the control can be performed longer in the energy-saving mode according to the delay. Accordingly, the more energy consumption can be suppressed while the environment in the inert atmosphere chamber 13 is returned according to the timing for introducing the board to the reflow furnace.

### [Second embodiment]

A reflow furnace according to a second embodiment has a configuration similar to the reflow furnace of the first embodiment. However, in the second embodiment, as described above, the operations of the heaters 11A to 11N is controlled in the energy-saving mode in order to maintain the inert atmosphere chamber 13 at the temperature lower than the first temperature. A processing content performed in the second embodiment will be described below.

### <Reference return time setting (teaching processing)>

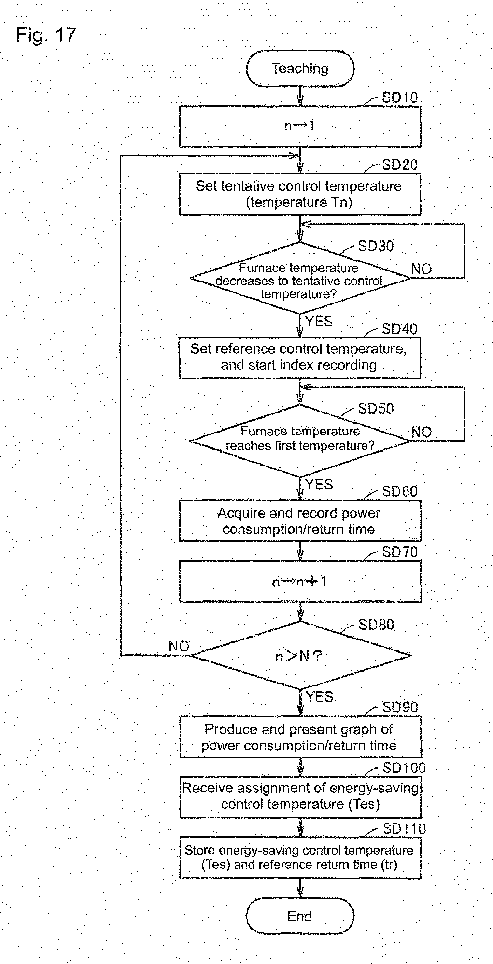

Fig. 17 is a flowchart of the teaching processing performed in the second embodiment.

Referring to Fig. 17, the controlled 101 initializes the variable n used in the teaching processing to 1 in Step SD10, and goes to the processing in Step SD20.

The controller 101 sets the control target temperature the inert atmosphere chamber 13 to a tentative control temperature Tn in Step SD20, and goes to the processing in Step SD30. The tentative control temperature Tn is a value that is previously decided while correlated with the value of the variable n. Information identifying N tentative control temperatures (T1 to TN) that are previously decided as the control target temperature in the teaching processing is stored in the memory 101B. In Step SD20, the controller 101 acquires the information identifying an nth tentative control temperature in the N tentative control temperatures from the memory 101B, and sets tentative control temperature. Therefore, the turn-on and-off of each of the heaters 11A to 11N are controlled such that the temperature (the atmospheric temperature of the seventh heating process) in the inert atmosphere chamber 13 is maintained at the tentative control temperature.

The N tentative control temperatures (T1 to TN) are lower than the temperature (first temperature) suitable for the heat treatment of the workpiece 90 in the inert atmosphere chamber 13.

In Step SD30, the controlled 101 determines whether the temperature (the atmospheric temperature of the seventh heating process) in the inert atmosphere chamber 13 has decreased to the tentative control temperature Tn. When the temperature has decreased to the tentative control temperature Tn, the controller 101 goes to the processing in Step SD40.

In Step SD40, the controller 101 returns the temperature control target in the inert atmosphere chamber 13 to the first temperature, and starts the detection of the index (in the second embodiment, the atmospheric temperature of the seventh heating process) in the inert atmosphere chamber 13. Then the controller 101 goes to the processing in Step SD50.

In Step SD50, the controller 101 determines whether the temperature in the inert atmosphere chamber 13 has increased to the first temperature. When the temperature in the inert atmosphere chamber 13 has increased to the first temperature, the controller 101 goes to the processing in Step SD60.

In Step SD60, the controlled 101 acquires the power consumption and the return time, and records the power consumption and the return time in the memory 101B. Then the controller 101 goes to the processing in Step SD70. The power consumption is power consumption in the heaters 11A to 11N until the temperature in the inert atmosphere chamber 13 is returned to the first temperature in Step SD60 since the control is started while the temperature control target in the inert atmosphere chamber 13 is changed to the tentative control temperature Tn in Step SD20. The return time is time until the atmospheric temperature reaches the first temperature in Step SD50 since the control target is returned to the first temperature in Step SD40. The term of "reach" may be substituted for the condition that is generally used to identify the return of the temperature such that "the first temperature is continuously retained for predetermined time since the atmospheric temperature reaches the first temperature".

The controller 101 updates the variable n by adding 1 to the variable n in Step SD70, and goes to processing in Step SD80.

In Step SD80, the controller 101 determines whether the value of the variable n exceeds "N" that is the number of time frames. The controlled 101 returns to the processing in Step SD20 when the value of the variable n does not exceed "N" yet, and the controller 101 goes to the processing in Step SD90 when the value of the variable n exceeds "N".

That is, the controller 101 acquires the "power consumption" and the "return time" for each of the N tentative control temperatures through the pieces of processing in Steps SD20 to SD80.

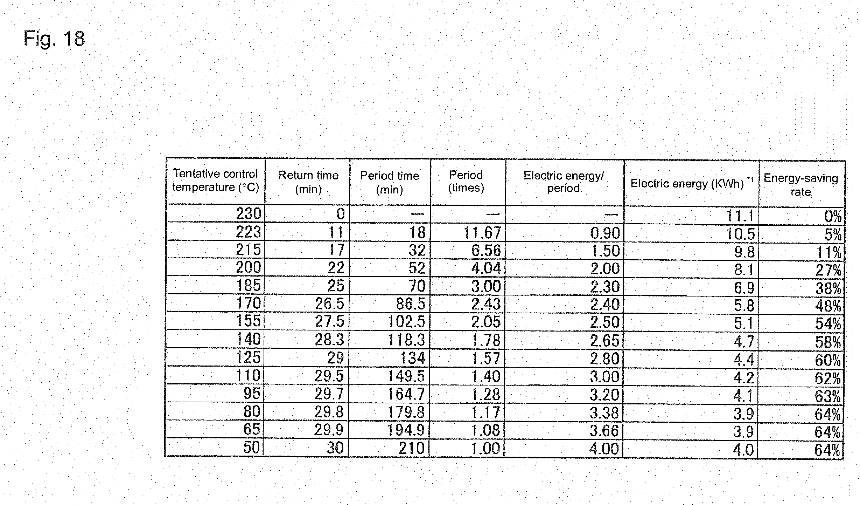

Fig. 18 illustrates an example of the data used in the teaching processing in the second embodiment, and the data includes the data acquired through the pieces of processing in Steps SD20 to SD80.

Fig. 18 illustrates pieces of data of items of the tentative control temperature and the return time, the period time, the period, the electric energy/period, the electric energy, and the energy-saving rate for each tentative control temperature.

The "tentative control temperature" means the Tn. The "return time" means the return time acquired in Step SD60 with respect to each tentative control temperature.

The "period time" means the time until the temperature in the inert atmosphere chamber 13 reaches the first temperature in Step SD50 since the control target is changed to the tentative control temperature in Step SD20.

The "period" means the number of times the period time can be repeated for a specific time (in this example, 3.5 hours (210 minutes)), and means the value that is obtained by dividing the "specific time" by the "period time".

The "electric energy/period" means electric energy that is consumed in the period time, and means the power consumption acquired in Step SD60.

The "electric energy" means the product of the "electric energy/period" and the "period", specifically means the power consumption that is estimated to be consumed for the specific time when the change of the control target to the tentative control temperature and the subsequent return to the first temperature are repeated.

Fig. 18 also illustrates the data in the case that, assuming that the tentative control temperature is set to the first temperature (230°C), the powers are continuously supplied to the heaters 11A to 11N for the specific time.

The "energy-saving rate" means a difference between the "electric energy" and the "electric energy" in the case that the "tentative control temperature" is set to "first temperature", and the "energy-saving rate" corresponds to the electric energy of which the consumption can be suppressed compared with the case that the continuous operation is performed for the specific time.

In Fig. 18, the pieces of data are indicated for the tentative control temperatures of 230°C (the continuous temperature control at the first temperature), 223°C, 215°C, 200°C, 185°C, 170°C, 155°C, 140°C, 125°C, 110°C. 95°C, 80°C, 65°C, and 50°C.

Referring to Fig. 18, the "electric energy" is "10.5 KWh" and "3.5 KWh" for the tentative control temperatures of 223°C and 80°C. In these time frames, the "electric energy" decreases with increasing tentative control temperature. The "electric energy" for the tentative control temperature of 80°C does not change from the "electric energy" for the tentative control temperature of 65°C. The "electric energy" is "4.0 KWh" for the tentative control temperature of 50°C, and increases slightly compared with the tentative control temperatures of 80°C and 65°C.

The "energy-saving rate" is "5%" and "64%" for the tentative control temperatures of 223°C and 80°C. The "energy-saving rate" exerts the tendency similar to the "electric energy" with respect to the tentative control temperature.

Referring to Fig. 17, in Step SD90, the controller 101 produces the screen data used to display the graphs indicating the changes in "power consumption" (the "electric energy" in Fig. 18) and "return time" (the "return time" in Fig. 18) with the change in tentative control temperature, and transmits the screen data to the PC 300. The graphs are displayed on the monitor of the PC 300 through the processing in Step SD90. Alternatively, the controlled 101 may include the monitor, and the graphs may be displayed on the monitor of the controller 101.

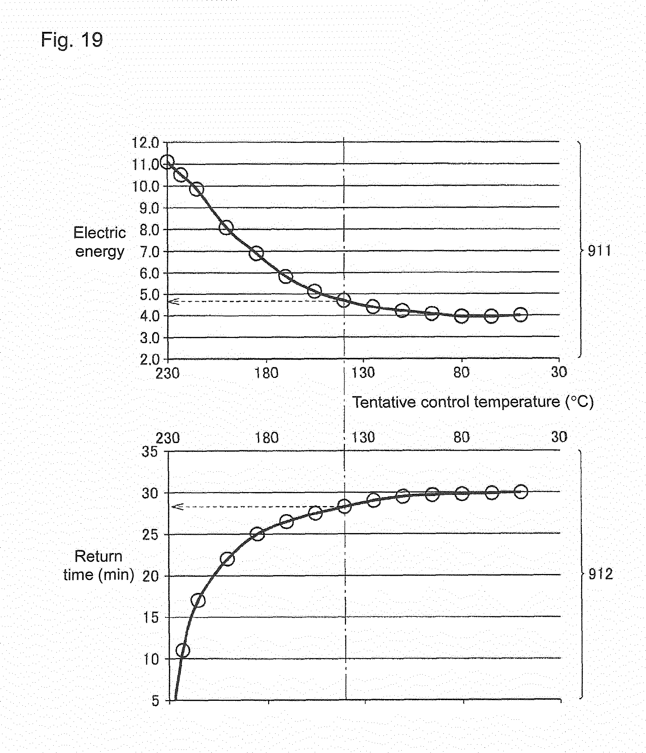

Fig. 19 schematically illustrates examples of the graphs displayed through processing in Step SD90.

Fig. 19 illustrates a graph 911 and a graph 912. The graph 911 indicates the change in "power consumption" (the "electric energy" in Fig. 18) with the change in tentative control temperature. The graph 912 indicates the change in "return time" (the "return time" in Fig. 18) with the change in tentative control temperature.

The horizontal position of the horizontal axis indicating the tentative control temperature is common to the graph 911 and the graph 912. Accordingly, when setting the control target temperature in the energy-saving mode as described later, the user can recognize the electric energy estimated to be consumed for the specific time and the time necessary to return the environment (temperature) in the inert atmosphere chamber 13 as information corresponding to the tentative control temperature that corresponds to the control target temperature, by seeing the graphs in Fig. 19.

The approximate function produced based on each piece of data is indicated by the thick line in each of the graph 911 and the graph 912. The controller 101 generates the approximate function based on the measured value of the electric energy or return time, which is associated with the change in tentative control temperature as illustrated in Fig. 18, and displays the approximate function together with the measured value as indicated by the graph 911 and the graph 912.

Referring to Fig. 17, in Step SD100, the controller 101 receives assignment of a temperature (hereinafter also referred to as an "energy-saving control temperature (Tes)") that is the temperature control target in the inert atmosphere chamber 13 in the energy-saving mode, during the actual operation. Then the controller 101 goes to the processing in Step SD110.

For example, the user can assign the energy-saving control temperature (Tes) while referring to the graphs illustrated in Fig. 19. Specifically, for example, the user performs the operation to specify the tentative control temperature by moving in the right or left direction the position of the alternate long and short dash line in Fig. 19 and the operation to assign the specified tentative control temperature as the energy-saving control temperature (Tes) on the PC 300, whereby information assigning the energy-saving control temperature (Tes) is input to the controller 101 from the PC 300 through the interface 101C.

Note that the time assigned as the energy-saving control temperature (Tes) is not limited to the temperature, which is indicated as the "tentative control temperature" in Fig. 18 while having the measured value of the electric energy or the like.

In specifying the tentative control temperature on the PC 300, the information indicating the electric energy and return time corresponding to the tentative control temperature may be displayed on the PC 300 as illustrated by the broken-line arrow in Fig. 19. For example, the display of the corresponding electric energy and return time is implemented as the CGI on the controller 101. That is, for example, the arithmetic device 101A executes the CGI program stored in the memory 101B in response to the request from the PC 300, whereby the data used to display the electric energy and return time corresponding to the energy-saving control temperature specified on the PC 300 is transmitted to the PC 300 from the controlled 101. In the case that the data in Fig. 18 is stored in the memory 101B, the arithmetic device 101A executes the CGI program using the data.

Referring to Fig. 17, in Step SD110, the controller 101 stores the energy-saving control temperature (Tes), the assignment of which is received in Step SD100, in the memory 101B, and stores the return time corresponding to the tentative control temperature equal to the energy-saving control temperature (Tes) in the approximate function or the measured value in Fig. 18 in the memory 101B as the "reference return time (tr)". Then the controller 101 ends the processing.

In the teaching processing of the second embodiment, as described above with reference to Fig. 14, the electric energy consumption estimated to be suppressed for the specific time may be presented according to the set energy-saving control temperature (Tes).

### <Normal operating control>

In the "normal operating processing" of the first embodiment in Fig. 15, the operating mode transitions from the normal mode to the energy-saving mode in response to the satisfaction of the predetermined condition. The operating mode is returned from the energy-saving mode to the normal mode on the condition that the remaining waiting time is less than the reference return time (tr).

In the normal mode of the second embodiment, the temperature control target in the inert atmosphere chamber 13 is set to the first temperature. In the energy-saving mode, the temperature control target in the inert atmosphere chamber 13 is changed to the energy-saving control temperature (Tes) lower than the first temperature.

In the second embodiment, when the heat treatment of the workpiece 90 is performed in the inert atmosphere chamber 13, the control temperature in the inert atmosphere chamber 13 is controlled at the first temperature. When the predetermined condition is satisfied, the reflow furnace is controlled in the energy-saving mode (the mode in which the temperature control target in the inert atmosphere chamber 13 is lower than that in the normal mode). Therefore, the power consumption can surely be suppressed in the heaters 11A to 11N.

### [Third embodiment]

As described in the first embodiment, the oxygen concentration in the inert atmosphere chamber 13 of the reflow furnace increases when the supply of the nitrogen gas to the inert atmosphere chamber 13 is interrupted. Accordingly, in order that the workpiece 90 is introduced to the inert atmosphere chamber 13 to melt the solder (of the workpiece 90) again, it is necessary to open the nitrogen valve 16 to decrease the oxygen concentration in the inert atmosphere chamber 13 to a proper concentration.

In a third embodiment, opening and closing of the nitrogen valve 16 is controlled in the energy-saving mode such that the oxygen concentration in the inert atmosphere chamber 13 is maintained at the concentration higher than in the normal mode. That is, in the third embodiment, the consumption of pressure energy is suppressed, and the energy consumption amount is expressed by a supply amount (consumption amount) of the nitrogen gas to the inert atmosphere chamber 13. A processing content performed in the third embodiment will be described below.

### <reference return time setting (teaching processing)>

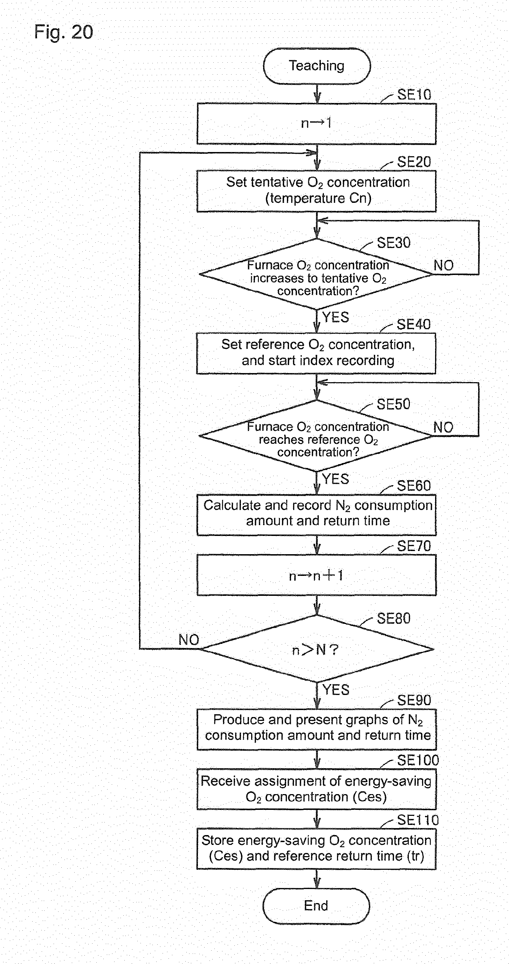

Fig. 20 is a flowchart of the teaching processing performed in the third embodiment.

Referring to Fig. 20, the controller 101 initializes the variable n used in the teaching processing to 1 in Step SE10, and goes to the processing in Step SE20.

The controller 101 sets an oxygen concentration control target in the inert atmosphere chamber 13 to a tentative oxygen concentration Cn in Step SE20, and goes to the processing in Step SE30. The tentative oxygen concentration Cn is a value that is previously decided while correlated with the value of the variable n. Information identifying N tentative oxygen concentrations (C1 to CN) that are previously decided as the oxygen concentration control target in the teaching processing is stored in the memory 101B. In Step SE20, the controller 101 acquires the information identifying an nth tentative oxygen concentration in the N tentative oxygen concentrations from the memory 101B, and sets tentative oxygen concentration. Therefore, the opening and closing of the nitrogen valve 16 are controlled such that the oxygen concentration in the inert atmosphere chamber 13 is maintained at the tentative oxygen concentration.

The N tentative oxygen concentrations (C1 to CN) are higher than the oxygen concentration (first concentration) suitable for the heat treatment of the workpiece 90 in the inert atmosphere chamber 13.

In Step SE30, the controller 101 determines whether the oxygen concentration in the inert atmosphere chamber 13 has increased to the tentative oxygen concentration Cn. When the oxygen concentration has increased to the tentative oxygen concentration Cn, the controller 101 goes to the processing in Step SE40.

In Step SE40, the controller 101 returns the oxygen concentration control target in the inert atmosphere chamber 13 to the first concentration, and starts the detection of the index (in the third embodiment, the oxygen concentration) in the inert atmosphere chamber 13. Then the controller 101 goes to the processing in Step SE50.

In Step SE50, the controller 101 determines whether the oxygen concentration in the inert atmosphere chamber 13 has decreased to the first concentration. When the oxygen concentration in the inert atmosphere chamber 13 has decreased to the first concentration, the controller 101 goes to the processing in Step SE60.

In Step SE60, the controller 101 acquires a nitrogen gas consumption amount and the return time, and records the nitrogen gas consumption amount and the return time in the memory 101B. Then the controller 101 goes to the processing in Step SE70. The nitrogen gas consumption amount is nitrogen gas amount introduced to the inert atmosphere chamber 13 through the nitrogen line 14 until the oxygen concentration in the inert atmosphere chamber 13 is returned to the first concentration in Step SE60 since the control is started while the oxygen concentration control target in the inert atmosphere chamber 13 is changed to the tentative oxygen concentration Cn in Step SE20. The return time is time until the oxygen concentration reaches the first concentration in Step SE50 since the control target is returned to the first concentration in Step SE40. The term of "reach" may be substituted for the condition that is generally used to identify the return of the concentration such that "the first concentration is continuously retained for predetermined time since the concentration reaches the first concentration".

The controlled 101 updates the variable n by adding 1 to the variable n in Step SE70, and goes to processing in Step SE80.

In Step SE80, the controller 101 determines whether the value of the variable n exceeds "N" that is the number of time frames. The controller 101 returns to the processing in Step SE20 when the value of the variable n does not exceed "N" yet, and the controller 101 goes to the processing in Step SE90 when the value of the variable n exceeds "N".

That is, the controller 101 acquires the "nitrogen gas consumption amount (N₂ consumption amount)" and the "return time" for each of the N tentative oxygen concentrations through the pieces of processing in Steps SE20 to SE80.

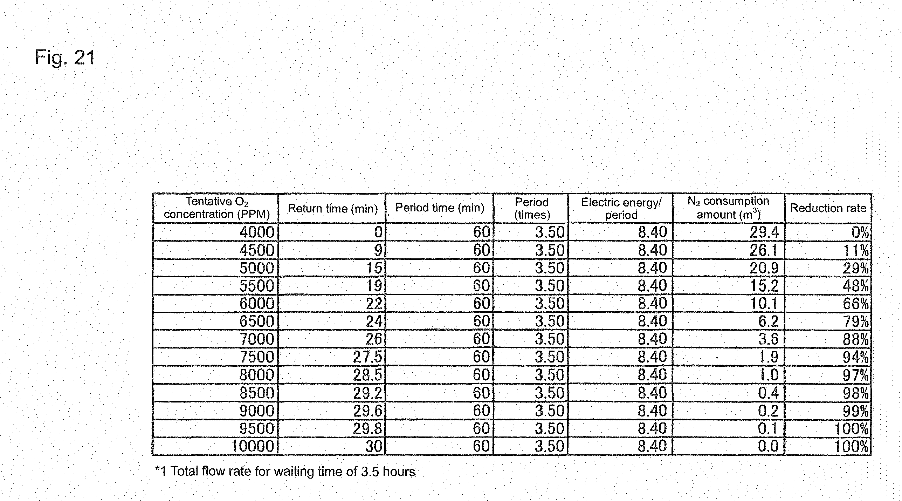

Fig. 21 illustrates an example of the data used in the teaching processing of the third embodiment, and the data includes the data acquired through the pieces of processing in Steps SE20 to SE80.

Fig. 21 illustrates pieces of data of items of the tentative oxygen concentration and the return time, the period time, the period, the consumption amount/period, the consumption amount, and the energy-saving for each tentative oxygen concentration.

The "tentative oxygen concentration" means the Cn. The "return time" means the return time acquired in Step SE60 with respect to each tentative oxygen concentration.

The "period time" is 60 minutes in this example. The "period" means the number of times the period time can be repeated for a specific time (in this example, 3.5 hours (210 minutes)), and means the value that is obtained by dividing the "specific time" by the "period time".

The "consumption amount/period" means a nitrogen gas consumption amount that is consumed in the period time, and means the consumption amount acquired in Step SE60.

The "consumption amount" means the product of the "consumption amount/period" and the "period", specifically means the nitrogen gas consumption amount that is estimated to be consumed for the specific time when the change of the control target to the tentative oxygen concentration and the subsequent return to the first concentration are repeated.

Fig. 21 also illustrates the data in the case that, assuming that the tentative oxygen concentration is set to the first concentration (4000 PPM), the inert atmosphere chamber 13 is maintained at the first concentration for the specific time.

The "energy-saving rate" means a difference between the "consumption amount" and the "consumption amount" in the case that the "tentative oxygen concentration" is set to "first concentration", and the " energy-saving rate" corresponds to the consumption amount of which the consumption can be suppressed compared with the case that the continuous operation is performed for the specific time.

In Fig. 21, the pieces of data are indicated for the tentative oxygen concentrations of 4000 PPM (the continuous control at the first concentration), 4500 PPM, 5000 PPM, 5500 PPM, 6000 PPM, 6500 PPM, 7000 PPM, 7500 PPM, 8000 PPM, 8500 PPM, 9000 PPM, 9500 PPM, and 10000 PPM.

Referring to Fig. 21, the "consumption amount" is "26.1 m³" for the tentative oxygen concentration of 4500 PPM. The "consumption amount" decreases with increasing tentative oxygen concentration.

The "energy-saving rate" is "11%" for the tentative oxygen concentration of 4500 PPM. The "energy-saving rate" exerts the tendency similar to the "consumption amount" with respect to the tentative oxygen concentration.

Referring to Fig. 20, in Step SE90, the controller 101 produces the screen data used to display the graphs indicating the changes in "consumption" amount" and "return time" with the change in tentative oxygen concentration, and transmits the screen data to the PC 300. The graphs are displayed on the monitor of the PC 300 through the processing in Step SE90. Alternatively, the controller 101 may include the monitor, and the graphs may be displayed on the monitor of the controller 101.

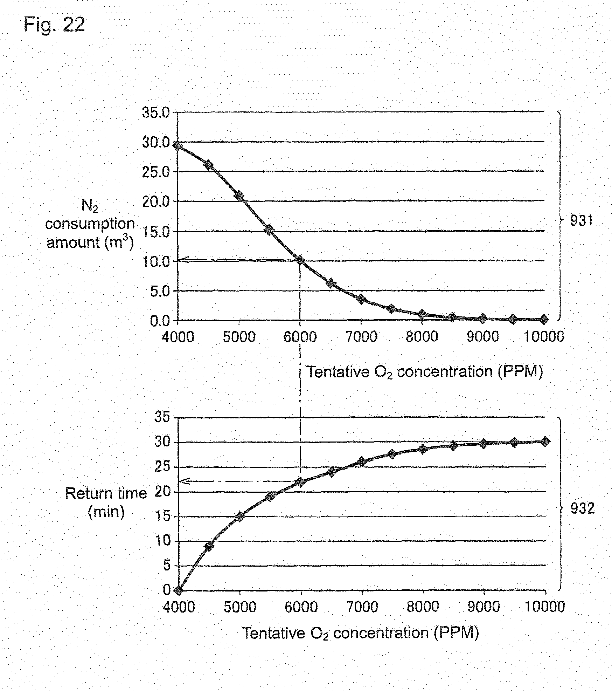

Fig. 22 schematically illustrates examples of the graphs displayed through processing in Step SE90.

Fig. 22 illustrates a graph 921 and a graph 922. The graph 921 indicates the change in "power consumption" (the "consumption amount" in Fig. 21) with the change in tentative oxygen concentration. The graph 922 indicates the change in "return time" (the "return time" in Fig. 21) with the change in tentative oxygen concentration.

The horizontal position of the horizontal axis indicating the tentative oxygen concentration is common to the graph 921 and the graph 922. Accordingly, when setting the control target concentration (energy-saving oxygen concentration) in the energy-saving mode as described later, the user can recognize the consumption amount estimated to be consumed for the specific time and the time necessary to return the environment ( concentration) in the inert atmosphere chamber 13 as information corresponding to the tentative oxygen concentration that corresponds to the energy-saving oxygen concentration, by seeing the graphs in Fig. 22.

The approximate function produced based on each piece of data is indicated by the thick line in each of the graph 921 and the graph 922. The controller 101 generates the approximate function based on the measured value of the consumption amount or return time, which is associated with the change in tentative oxygen concentration as illustrated in Fig. 21, and displays the approximate function together with the measured value as indicated by the graph 921 and the graph 922.

Referring to Fig. 20, in Step SE100, the controller 101 receives assignment of a temperature (hereinafter also referred to as an "energy-saving oxygen concentration (Ces)") that is the temperature control target in the inert atmosphere chamber 13 in the energy-saving mode, during the actual operation. Then the controller 101 goes to the processing in Step SE110.

For example, the user can assign the energy-saving oxygen concentration (Ces) while referring to the graph illustrated in Fig. 22. Specifically, for example, the user performs the operation to specify the tentative oxygen concentration by moving in the right or left direction the position of the alternate long and short dash line in Fig. 22 and the operation to assign the specified tentative oxygen concentration as the energy-saving oxygen concentration (Ces) on the PC 300, whereby information assigning the energy-saving oxygen concentration (Ces) is input to the controller 101 from the PC 300 through the interface 101C.

Note that the concentration assigned as the energy-saving oxygen concentration (Ces) is not limited to the concentration, which is indicated as the "tentative oxygen concentration" in Fig. 21 while having the measured value of the consumption amount or the like.

In specifying the tentative oxygen concentration on the PC 300, the information indicating the consumption amount and return time corresponding to the tentative oxygen concentration may be displayed on the PC 300 as illustrated by the broken-line arrow in Fig. 22. For example, the display of the corresponding consumption amount and return time is implemented as the CGI on the controller 101. That is, for example, the arithmetic device 101A executes the CGI program stored in the memory 101B in response to the request from the PC 300, whereby the data used to display the consumption amount and return time corresponding to the energy-saving oxygen concentration specified on the PC 300 is transmitted to the PC 300 from the controller 101. In the case that the data in Fig. 21 is stored in the memory 101B, the arithmetic device 101A executes the CGI program using the data.

Referring to Fig. 20, in Step SE110, the controller 101 stores the energy-saving oxygen concentration (Ces), the assignment of which is received in Step SE100, in the memory 101B, and stores the return time corresponding to the tentative oxygen concentration equal to the energy-saving oxygen concentration (Ces) in the approximate function or the measured value in Fig. 21 in the memory 101B as the "reference return time (tr)". Then the controller 101 ends the processing.

In the teaching processing of the third embodiment, as described above with reference to Fig. 14, the consumption amount estimated to be suppressed for the specific time may be presented according to the set energy-saving oxygen concentration (Ces).

### <Normal operating control>

In the "normal operating processing" of the first embodiment in Fig. 15, the operating mode transitions from the normal mode to the energy-saving mode in response to the satisfaction of the predetermined condition. The operating mode is returned from the energy-saving mode to the normal mode on the condition that the remaining waiting time is less than the reference return time (tr).

In the normal mode of the third embodiment, the oxygen concentration control target in the inert atmosphere chamber 13 is set to the first concentration. In the energy-saving mode, the oxygen concentration control target in the inert atmosphere chamber 13 is changed to the energy-saving oxygen concentration (Ces) higher than the first concentration.

In the third embodiment, when the heat treatment of the workpiece 90 is performed in the inert atmosphere chamber 13, the oxygen concentration in the inert atmosphere chamber 13 is controlled at the first concentration or less. When the predetermined condition is satisfied, the reflow furnace is controlled in the energy-saving mode (the mode in which the oxygen concentration control target in the inert atmosphere chamber 13 is higher than that in the normal mode). Therefore, the nitrogen gas consumption amount can surely be suppressed.

### [Modification]

In the above embodiment, the oxygen concentration in the atmosphere chamber 13 is decreased by introducing the nitrogen gas to the inert atmosphere chamber 13. However, as described above, the control is limited to such the special case that the solder used in the workpiece 90 is the lead-free solder. That is, in the reflow furnace of the present invention, it is conceivable that the nitrogen gas is not necessarily introduced to the inert atmosphere chamber 13.

The disclosed embodiments and modification are described only by way of example, but not restrictive. The scope of the present invention is indicated by not the description but the claims, and the meanings equivalent to the claims and all the changes within the claims are included in the present invention.

It is noted that the embodiments and modification are solely implemented, or properly implemented by a combination thereof as needed basis.

### DESCRIPTION OF SYMBOLS

- 11A to 11N: heater
- 16: N₂ valve
- 22: temperature sensor
- 80: O₂ concentration sensor
- 100: reflow furnace
- 101: controller

## Claims

1. A control device (100) for a furnace, the control device (100) comprising a control unit (101) configured to control an operation of a supply unit, the supply unit being configured to supply energy into the furnace,
wherein the control unit (101) operates the supply unit according to a first condition that the furnace is maintained in a first state, in which an object to be heated is subjected to heat treatment,
the control unit (101) operates the supply unit according to a second condition that the furnace is controlled in a state in which less energy is consumed compared with the maintenance of the state in the furnace in the first state, when a predetermined condition is satisfied,
the control unit (101) comprises a storage unit in which reference return time is stored, the reference return time being time necessary to return the furnace to the first state from the state in which the supply unit is operated according to the second condition, and
the control unit (101) operates the supply unit such that the furnace is maintained in the first state, when remaining time to time the furnace should be returned to the first state is less than or equal to the reference return time while the supply unit is operated according to the second condition.

2. The control device (100) according to claim 1, wherein a plurality of contents are stored in the storage unit as a content of the second condition, and
the control unit (101) measures and presents reserve return time and a consumption energy amount with respect to each of the plurality of contents of the second condition, the reserve return time being time necessary to return the furnace to the first state from control under the second condition, the consumption energy amount being an energy amount consumed by the supply unit.

3. The control device (100) according to claim 2, further comprising an input unit configured to input the reference return time,
wherein the control unit (101) presents the consumption energy amount corresponding to the reserve return time when time input to the input unit as the reference return time is the reserve return time in measurement results of the reserve return time and the consumption energy amount.

4. The control device (100) according to claim 1, wherein the control unit (101) interrupts the supply of energy to the furnace by the supply unit in the control under the second condition.

5. The control device (100) according to claim 1, wherein the first state is a state in which a temperature in the furnace is greater than or equal to a specific temperature, and
in the control under the second condition, the control unit (101) maintains the furnace at a temperature lower than the specific temperature.

6. The control device (100) according to claim 1, wherein the first state is a state in which an oxygen concentration in the furnace is less than or equal to a specific concentration, and
in the control under the second condition, the control unit (101) maintains the furnace at an oxygen concentration higher than the specific concentration.

7. The control device (100) according to claim 1, wherein the predetermined condition is a condition that the object to be heated does not exist in the furnace.

8. The control device (100) according to claim 7, wherein time when the control should be performed under the second condition is greater than or equal to the reference return time in the predetermined condition.

9. The control device (100) according to claim 8, wherein the time when the control should be performed under the second condition is decided based on whether the object to be heated exists in a preceding process of the furnace.

10. A furnace comprising:
the control device (100) according to claim 1; and
a supply unit (11A to 11N, 12A to 12N, and 16) configured to supply energy into the furnace.

11. A computer-readable storage medium in which a program is non-transiently recorded, the program being executable by a computer configured to control an operation of a supply unit, the supply unit being configured to supply energy into a furnace, the program causing the computer to perform the steps of:
operating the supply unit according to a first condition that the furnace is maintained in a first state, in which an object to be heated is subjected to heat treatment;
operating the supply unit according to a second condition that the furnace is controller in a state in which less energy is consumed compared with the maintenance of the furnace in the first state, when a predetermined condition is satisfied; and
operating the supply unit such that the furnace is maintained in the first state, when remaining time to time the furnace should be returned to the first state is less than or equal to reference return time while the supply unit is operated according to the second condition, the reference return time being time necessary to return the furnace to the first state from the state in which the supply unit is operated according to the second condition.

12. A furnace control method in which a furnace control device control an operation of a supply unit, the supply unit being configured to supply energy into the furnace, the furnace control method comprising the steps of:
operating the supply unit according to a first condition that the furnace is maintained in a first state, in which an object to be heated is subjected to heat treatment;
operating the supply unit according to a second condition that the furnace is controlled in a state in which less energy is consumed compared with the maintenance of the furnace in the first state, when a predetermined condition is satisfied; and
operating the supply unit such that the furnace is maintained in the first state, when remaining time to time the furnace should be returned to the first state is less than or equal to reference return time while the supply unit is operated according to the second condition, the reference return time being time necessary to return the furnace to the first state from the state in which the supply unit is operated according to the second condition.

## Amended claims

### Amended claims under Art. 19.1 PCT

1. (Amended) A control device (100) for a furnace, the control device (100) comprising a control unit (101) configured to control an operation of a supply unit, the supply unit being configured to supply energy into the furnace,
wherein the control unit (101) operates the supply unit according to a first condition that the furnace is maintained in a first state, in which an object to be heated is subjected to heat treatment,
the control unit (101) operates the supply unit according to a second condition that the furnace is controller in a state in which less energy is consumed compared with the maintenance of the state in the furnace in the first state, when a predetermined condition is satisfied,
the control unit (101) comprises a storage unit in which reference return time is stored, the reference return time being time necessary to return the furnace to the first state from the state in which the supply unit is operated according to the second condition,
the control unit (101) operates the supply unit such that the furnace is maintained in the first state, when remaining time to time the furnace should be returned to the first state is less than or equal to the reference return time while the supply unit is operated according to the second condition, and
the control unit (101) measures and presents reserve return time and a consumption energy amount, the reserve return time being time necessary to return the furnace to the first state from control under the second condition, the consumption energy amount being an energy amount consumed during the reserve return time by the supply unit.

2. (Amended) The control device (100) according to claim 1, wherein a plurality of contents are stored in the storage unit as a content of the second condition, and
the control unit (101) measures and presents the reserve return time and the consumption energy amount with respect to each of the plurality of contents of the second condition.

3. The control device (100) according to claim 2, further comprising an input unit configured to input the reference return time,
wherein the control unit (101) presents the consumption energy amount corresponding to the reserve return time when time input to the input unit as the reference return time is the reserve return time in measurement results of the reserve return time and the consumption energy amount.

4. The control device (100) according to claim 1, wherein the control unit (101) interrupts the supply of energy to the furnace by the supply unit in the control under the second condition.

5. The control device (100) according to claim 1, wherein the first state is a state in which a temperature in the furnace is greater than or equal to a specific temperature, and
in the control under the second condition, the control unit (101) maintains the furnace at a temperature lower than the specific temperature.

6. The control device (100) according to claim 1, wherein the first state is a state in which an oxygen concentration in the furnace is less than or equal to a specific concentration, and
in the control under the second condition, the control unit (101) maintains the furnace at an oxygen concentration higher than the specific concentration.

7. The control device (100) according to claim 1, wherein the predetermined condition is a condition that the object to be heated does not exist in the furnace.

8. The control device (100) according to claim 7, wherein time when the control should be performed under the second condition is greater than or equal to the reference return time in the predetermined condition.

9. The control device (100) according to claim 8, wherein the time when the control should be performed under the second condition is decided based on whether the object to be heated exists in a preceding process of the furnace.

10. A furnace comprising:
the control device (100) according to claim 1; and
a supply unit (11A to 11N, 12A to 12N, and 16) configured to supply energy into the furnace.

11. (Amended) A computer-readable storage medium in which a program is non-transiently recorded, the program being executable by a computer configured to control an operation of a supply unit, the supply unit being configured to supply energy into a furnace,
the program causing the computer to perform the steps of:
operating the supply unit according to a first condition that the furnace is maintained in a first state, in which an object to be heated is subjected to heat treatment;
operating the supply unit according to a second condition that the furnace is controlled in a state in which less energy is consumed compared with the maintenance of the furnace in the first state, when a predetermined condition is satisfied;
operating the supply unit such that the furnace is maintained in the first state, when remaining time to time the furnace should be returned to the first state is less than or equal to reference return time while the supply unit is operated according to the second condition, the reference return time being time necessary to return the furnace to the first state from the state in which the supply unit is operated according to the second condition; and
measuring and presenting reserve return time and a consumption energy amount, the reserve return time being time necessary to return the furnace to the first state from control under the second condition, the consumption energy amount being an energy amount consumed during the reserve return time by the supply unit.

12. (Amended) A furnace control method in which a furnace control device control an operation of a supply unit, the supply unit being configured to supply energy into the furnace, the furnace control method comprising the steps of:
operating the supply unit according to a first condition that the furnace is maintained in a first state, in which an object to be heated is subjected to heat treatment;
operating the supply unit according to a second condition that the furnace is controlled in a state in which less energy is consumed compared with the maintenance of the furnace in the first state, when a predetermined condition is satisfied;
operating the supply unit such that the furnace is maintained in the first state, when remaining time to time the furnace should be returned to the first state is less than or equal to reference return time while the supply unit is operated according to the second condition, the reference return time being time necessary to return the furnace to the first state from the state in which the supply unit is operated according to the second condition; and
measuring and presenting reserve return time and a consumption energy amount, the reserve return time being time necessary to return the furnace to the first state from control under the second condition, the consumption energy amount being an energy amount consumed during the reserve return time by the supply unit.
